# EUROPÄISCHE PATENTSCHRIFT

(11) **EP 4 404 329 B1**
(45) Veröffentlichungstag und Bekanntmachung des Hinweises auf die Patenterteilung: **20.05.2026**
(21) Anmeldenummer: 23151998.4
(22) Anmeldetag: 17.01.2023
(51) Int. Cl.: H01M 10/48, G01R 31/367, G01R 31/392, H01M 10/44

(54) **SYSTEM MIT EINEM AKKU UND VERFAHREN ZUM BETREIBEN EINES SYSTEMS MIT EINEM AKKU**
SYSTEM WITH A RECHARGEABLE BATTERY AND METHOD FOR OPERATING A SYSTEM WITH A RECHARGEABLE BATTERY
SYSTÈME COMPRENANT UNE BATTERIE RECHARGEABLE ET PROCÉDÉ DE FONCTIONNEMENT D'UN SYSTÈME COMPRENANT UNE BATTERIE RECHARGEABLE

(43) Veröffentlichungstag der Anmeldung: 24.07.2024
(73) Patentinhaber: Vorwerk & Co. Interholding GmbH, 42275 Wuppertal (DE)
(72) Erfinder: SAUERWALD, Andres, 46238 Bottrop (DE); BEZSONOV, Viktor, 40211 Düsseldorf (DE); ISENBERG, Gerhard, 50668 Köln (DE)
(74) Vertreter: Von Rohr Patentanwälte Partnerschaft mbB

(56) Entgegenhaltungen:
- DE-A1- 102020 214 182
- DE-A1- 102021 002 742
- DE-A1- 102021 203 868

## Beschreibung

Die vorliegende Erfindung betrifft ein Verfahren zum Betreiben eines Systems mit einem Akku sowie ein System mit einem Akku.

Insbesondere betrifft die vorliegende Erfindung das Problem der kalendarischen Alterung von Akkus.

Es ist bekannt, dass bei Akkus, insbesondere Lithium-Ionen-Akkus, mit zunehmender Lebensdauer des Akkus eine Alterung erfolgt. Diese Alterung äußert sich in einer Abnahme der Leistungsfähigkeit des Akkus, insbesondere darin, dass die Kapazität des Akkus, also die dem Akku maximal entnehmbare Ladungsmenge, abnimmt bzw. der Innenwiderstand des Akkus zunimmt. Dabei lassen sich verschiedene Arten der Alterung unterscheiden, nämlich eine kalendarische Alterung und eine zyklische Alterung.

Eine kalendarische Alterung eines Akkus ist eine Alterung, die selbst dann erfolgt, wenn der Akku nur gelagert bzw. nicht benutzt, insbesondere weder aktiv (z. B. durch Benutzung) entladen noch geladen wird.

Eine zyklische Alterung eines Akkus ist eine Alterung, die durch eine Nutzung des Akkus, insbesondere Lade- und Entladevorgänge, erfolgt. Bei starker Nutzung bzw. einer Vielzahl von Lade- und Entladevorgängen altert ein Akku schneller als bei geringer Nutzung bzw. wenigen Lade- und Entladevorgängen. Ferner ist die zyklische Alterung von einer Vielzahl von Parametern, beispielsweise den Lade- und Entladeströmen und der Höhe der Entladungen und Aufladungen abhängig.

Eine direkte Messung der Alterung bzw. des Alterungszustands eines Akkus ist jedoch schwierig bzw. im täglichen Gebrauch des Akkus nicht praktikabel.

Die DE 10 2020 214182 A1 betrifft ein Verfahren zum Ermitteln eines Alterungszustands einer Gerätebatterie eines batteriebetriebenen Geräts, insbesondere einer Fahrzeugbatterie eines elektrisch betriebenen Fahrzeugs, unter Berücksichtigung einer kalendarischen Alterung, mit folgenden Schritten: Nach Feststellen eines Beginns einer Inaktivitätsphase, Bestimmen eines Ladezustands und einer Batterietemperatur zu regelmäßigen Zeitpunkten; bei Aktivieren des Geräts, Bereitstellen eines kalendarischen Alterungszustands abhängig von einem Verlauf der Batterietemperatur, die sich aus den gemessenen Batterietemperaturen während der Inaktivitätsphase ergibt, und abhängig von einem Verlauf des Ladezustands, der aus einem oder mehreren der während der Inaktivitätsphase gemessenen Ladezustände bestimmt wird, mithilfe eines vorgegebenen Alterungszustandsmodells.

Die DE 10 2021 203868 A1 betrifft ein Verfahren zum Bereitstellen eines elektrochemischen Batteriemodells und eines Alterungszustandsmodells für eine Gerätebatterie. Das Alterungszustandsmodell umfasst zumindest ein physikalisches Alterungsmodell basierend auf einem weiteren Differenzialgleichungssystem und ist ausgebildet, um einen Alterungszustand abhängig von Betriebsgrößenverläufen der Gerätebatterie zu modellieren. Das physikalische Alterungsmodell wird verwendet, um einen Alterungszustand zu ermitteln.

Die DE 10 2021 002742 A1 betrifft ein Verfahren zur Prognose des Kapazitäts- und Innenwiderstandsverlaufs eines elektrochemischen Systems, wie einer Batterie. Bei dem Verfahren werden Ereignisse auf Basis der Analyse und Bewertung von Belastungszeitfunktionen des elektrochemischen Systems, die Betriebsdaten von realen Anwendungen oder Simulationsergebnissen, unter Berücksichtigung vorgebbarer Kriterien bestimmt. Dabei werden Phasen mit sehr geringen und langsamen Veränderungen des Ladezustands als Ereignisse kalendarischer Alterung mit unterschiedlichen mittleren Ladezustand, Temperaturbereich und Stromoberschwingungen erfasst bzw. behandelt.

Der vorliegenden Erfindung liegt deshalb die Aufgabe zugrunde, eine Lösung anzugeben, mit der ein Alterungszustand, insbesondere ein kalendarischer Alterungszustand, eines Akkus zuverlässig und/oder auf einfache Weise bestimmt werden kann.

Die der Erfindung zugrunde liegende Aufgabe wird durch ein Verfahren gemäß Anspruch 1 oder ein System gemäß Anspruch 13 gelöst. Vorteilhafte Weiterbildungen sind Gegenstand der Unteransprüche.

Gemäß einem ersten Aspekt betrifft die vorliegende Erfindung ein Verfahren zum Betreiben eines Systems mit einem Akku, wobei der Akku insbesondere als Lithium-Ionen-Akku ausgebildet ist. Bei dem Verfahren werden/wird ein Ladezustand des Akkus und/oder eine Temperatur des Akkus aufgezeichnet, indem der Ladezustand und/oder die Temperatur zu mehreren Zeitpunkten automatisch, insbesondere mittels einer Messeinrichtung des Systems, gemessen bzw. ermittelt und zumindest temporär gespeichert werden/wird. Mittels der gespeicherten Ladezustände und/oder Temperaturen wird ein kalendarischer Alterungszustand des Akkus automatisch bestimmt.

Die Aufzeichnung der Ladezustände und/oder Temperaturen ermöglicht auf einfache und kostengünstige Weise eine zuverlässige Bestimmung des kalendarischen Alterungszustands des Akkus, wie im Folgenden noch näher erläutert wird.

Als Maß für den kalendarischen Alterungszustand des Akkus wird insbesondere eine Abnahme einer Kapazität des Akkus gegenüber einer Nennkapazität und/oder eine Zunahme eines Innenwiderstands des Akkus gegenüber einem Nennwiderstand bestimmt. Die Kapazitätsabnahme und/oder Innenwiderstandszunahme stellen zuverlässige und/oder einfach bestimmbare Größen zur Repräsentation des Alterungszustands dar.

Zur Bestimmung des kalendarischen Alterungszustands wird vorzugsweise eine Alterungsfunktion verwendet, die verschiedenen Lagerladezuständen und/oder Lagertemperaturen eines Akkutyps jeweils einen kalendarischen Alterungszustand nach einer Lagerung für einen oder mehrere definierte Zeiträume zuordnet. Die Alterungsfunktion ist insbesondere empirisch ermittelt und/oder akkutypspezifisch. Die Verwendung der Alterungsfunktion ermöglicht auf einfache und zuverlässige Weise eine schnelle und einfache Bestimmung des kalendarischen Alterungszustands.

Zur Ermittlung der Alterungsfunktion werden vorzugsweise Messreihen durchgeführt, bei denen mehrere Akkus des Akkutyps für den definierten Zeitraum oder die definierten Zeiträume mit verschiedenen Lagerladezuständen und/oder bei verschiedenen Lagertemperaturen gelagert werden, wobei am Ende des definierten Zeitraums bzw. der definierten Zeiträume der jeweilige kalendarische Alterungszustand, insbesondere eine Abnahme der Kapazität der Akkus gegenüber einer Nennkapazität und/oder eine Zunahme des Innenwiderstands der Akkus gegenüber einem Nennwiderstand, gemessen wird. Dies ermöglicht eine genaue Ermittlung der Alterungsfunktion eines bestimmten Akkutyps.

Die Alterungsfunktion ist vorzugsweise für den jeweiligen Akkutyp spezifisch. Insbesondere sind mehrere Alterungsfunktionen für unterschiedliche Akkutypen in einer Datenbank elektronisch gespeichert. Ferner ist dem Akku vorzugsweise eine Information zu dem Akkutyp zugeordnet und wird mittels der Information die dem Akkutyp entsprechende Alterungsfunktion zur Bestimmung des kalendarischen Alterungszustands des Akkus ausgewählt. Die Verwendung einer akkutypspezifischen Alterungsfunktion ermöglicht eine besonders zuverlässige und genaue Bestimmung des Alterungszustands eines Akkus.

Die Bestimmung des Alterungszustands wird vorzugsweise mehrfach und/oder regelmäßig wiederholt. Insbesondere wird nach jeder Messung des Ladezustands und/oder der Temperatur des Akkus der Alterungszustand neu bestimmt. Weiter vorzugsweise gibt das System eine Mitteilung über den bestimmten Alterungszustand aus, beispielsweise über eine mit dem Akku datentechnisch verbundene bzw. verbindbare Benutzerschnittstelle bzw. App des Systems. Durch die Mitteilung kann ein Nutzer des Akkus über den Alterungszustand informiert werden bzw. kann der Alterungszustand überwacht werden.

Auf Basis des bestimmten Alterungszustands wird vorzugsweise eine Mitteilung, insbesondere eine Empfehlung, zur Nutzung und/oder Lagerung des Akkus ausgegeben, insbesondere über eine Benutzerschnittstelle bzw. App des Systems. Hierdurch kann ein Nutzer die Benutzung des Akkus so anpassen bzw. verändern, dass die Lebensdauer des Akkus verlängert und/oder die Alterung des Akkus verlangsamt wird.

Alternativ oder zusätzlich kann auf Basis des bestimmten Alterungszustands ein Ladeverhalten des Systems automatisch angepasst werden, beispielsweise indem die Ladegeschwindigkeit bzw. Ladeleistung und/oder die Lademenge reduziert werden/wird. Insbesondere können verschiedenen Alterungszuständen des Akkus ein maximaler Ladezustand, ein minimaler Ladezustand und/oder ein maximaler Ladestrom zugeordnet sein. Besonders bevorzugt wird das Ladeverhalten des Systems derart angepasst, dass der dem Alterungszustand des Akkus zugeordnete maximale Ladezustand nicht überschritten wird, der dem Alterungszustand zugeordnete minimale Ladezustand nicht unterschritten wird und/oder der dem Alterungszustand zugeordnete maximale Ladestrom nicht überschritten wird. Dies ist einer längeren Lebensdauer bzw. langsameren Alterung des Akkus zuträglich.

Die Messung und Speicherung des Ladezustands und/oder der Temperatur erfolgt vorzugsweise in regelmäßigen Abständen. Dies ermöglicht eine kontinuierliche Aufzeichnung bzw. regelmäßige Aktualisierung sowie eine genaue Bestimmung des Alterungszustands.

Die Abstände der Zeitpunkte, zu denen Ladezustand und/oder Temperatur gemessen werden, werden vorzugsweise in Abhängigkeit von einer Nutzung, des Ladezustands und/oder der Temperatur des Akkus angepasst. Dies ist einer genauen und/oder zuverlässigen Bestimmung des Alterungszustands zuträglich.

Vorzugsweise werden mit sinkendem Ladezustand und/oder bei Erreichen oder Unterschreiten eines unteren Grenzwerts des Ladezustands die zeitlichen Abstände, in denen der Ladezustand und/oder die Temperatur gemessen werden, vergrößert. Alternativ oder zusätzlich wird bei Erreichen oder Unterschreiten eines unteren Grenzwerts des Ladezustands die Aufzeichnung des Ladezustands und/oder der Temperatur beendet oder unterbrochen. Hierdurch kann der Stromverbrauch der Messung reduziert und somit verhindert werden, dass eine Tiefentladung des Akkus erfolgt bzw. eine vorgegebene Mindestruhespannung des Akkus erreicht oder unterschritten wird. Dies ist insbesondere bei Lithium-Ionen-Akkus wichtig, da diese nach Erreichen oder Unterschreiten einer vorgegebenen Mindestruhespannung nicht wieder geladen werden dürfen, da dies zu einer Beschädigung oder Zerstörung des Akkus führen kann.

Vorzugsweise wird automatisch erfasst, wenn ein vordefinierter Temperaturgrenzwert erreicht, unterschritten oder überschritten wird. Insbesondere werden, wenn ein vordefinierter Temperaturgrenzwert erreicht, unterschritten oder überschritten wird, der Ladezustand und/oder die Temperatur gemessen und gespeichert. Diese temperaturgrenzwertabhängige Messung und Speicherung erfolgt insbesondere zusätzlich zu einer Messung und Speicherung des Ladezustands und/oder der Temperatur in regelmäßigen Abständen. Es hat sich nämlich gezeigt, dass extreme Temperaturwerte einen besonders großen Einfluss auf die kalendarische Alterung des Akkus haben, so dass durch die zusätzliche temperaturgrenzwertabhängige Messung und Speicherung eine besonders zuverlässige Bestimmung des kalendarischen Alterungszustands ermöglicht wird.

Der Akku kann mehrere Zellen aufweisen, wobei in diesem Fall vorzugsweise die Aufzeichnung des Ladezustands und/oder der Temperatur für einzelne oder alle der Zellen separat erfolgt. Dies ist einer möglichst genauen Bestimmung des Alterungszustands zuträglich.

Vorzugsweise werden zu den Zeitpunkten, zu denen der Ladezustand und/oder die Temperatur gemessen werden, zusätzlich Informationen zu Ladevorgängen und/oder Entladevorgängen des Akkus, die während des jeweiligen Zeitpunkts stattfinden, aufgezeichnet. Durch diese zusätzlichen Informationen kann die Alterung des Akkus genauer bestimmt werden. Beispielsweise beeinflusst ein Lade- bzw. Entladevorgang die Temperatur des Akkus, so dass es wichtig ist, zu wissen, ob die gemessene Temperatur einer Lager- bzw. Umgebungstemperatur des Akkus entspricht oder durch einen Lade- oder Entladevorgang bedingt ist. Die Informationen umfassen daher insbesondere einen Ladestrom oder Entladestrom des Ladevorgangs bzw. Entladevorgangs. Alternativ oder zusätzlich umfassen die Informationen eine Dauer des Ladevorgangs oder Entladevorgangs, so dass abgeschätzt werden kann, ob der gemessene Ladezustand einem Lagerladezustand entspricht bzw. die gemessene Temperatur einer Lagertemperatur entspricht oder ob der Ladezustand und/oder die Temperatur durch den jeweiligen Ladevorgang bzw. Entladevorgang bedingt sind.

Wenn festgestellt wird bzw. wurde, dass während der Messung von Ladezustand und/oder Temperatur der Akku geladen oder entladen wird/wurde, wird dies vorzugsweise berücksichtigt. Insbesondere kann die Messung zu einem späteren Zeitpunkt wiederholt werden, vorzugsweise nachdem der Lade- bzw. Entladevorgang beendet wurde. Ferner ist es möglich, bei der Bestimmung des kalendarischen Alterungszustands zu berücksichtigen, dass der Akku während der Messung von Ladezustand und/oder Temperatur geladen oder entladen wurde, beispielsweise in dem die gemessenen Werte mit einer geringeren Gewichtung bei der Bestimmung des Alterungszustands gewichtet werden oder die Messung nicht zur Bestimmung des Alterungszustands verwendet wird.

Es ist bevorzugt, dass zusätzlich zum kalendarischen Alterungszustand bzw. zur kalendarischen Alterung ein zyklischer Alterungszustand bzw. eine zyklische Alterung des Akkus bestimmt wird. Hierzu werden/wird insbesondere eine Entladerate, Entladungstiefe, Akku- bzw. Zelltemperatur, Nachladestromstärke und/oder Nachladehöhe aufgezeichnet. Durch die zusätzliche Berücksichtigung der zyklischen Alterung des Akkus kann eine genauere Bestimmung bzw. Angabe des Alterungszustands des Akkus erfolgen.

Gemäß einem weiteren, auch unabhängig realisierbaren Aspekt betrifft die vorliegende Erfindung ein System mit einem Akku, der vorzugsweise ein Lithium-Ionen-Akku ist und insbesondere zum Betreiben eines Haushaltsgeräts ausgebildet ist.

Das System ist vorzugsweise zum Durchführen des hierin beschriebenen Verfahrens ausgebildet.

Das System weist vorzugsweise ein mit dem Akku betreibbares und datentechnisch verbundenes oder verbindbares Gerät, insbesondere Haushaltsgerät, ein insbesondere mit dem Akku und/oder Gerät datentechnisch verbundenes oder verbindbares Kommunikationsgerät, und/oder eine insbesondere mit dem Kommunikationsgerät, dem Gerät und/oder dem Akku datentechnisch verbundene oder verbindbare Datenbank auf.

Vorzugsweise enthält die Datenbank eine Alterungsfunktion zur Bestimmung eines kalendarischen Alterungszustands des Akkus, wobei die Alterungsfunktion verschiedenen Lagerladezuständen und/oder Lagertemperaturen des Akkus jeweils einen kalendarischen Alterungszustand nach einer Lagerung für einen oder mehrere definierte Zeiträume zuordnet.

Das System weist vorzugsweise eine Messeinrichtung zur Messung des Ladezustands und/oder der Temperatur des Akkus sowie eine Kommunikationsschnittstelle zur Übertragung von mit der Messeinrichtung gemessenen Messwerten auf.

Insbesondere werden durch das System entsprechende Vorteile des Verfahrens erreicht.

Die vorgenannten Aspekte, Merkmale und Verfahrensschritte der vorliegenden Erfindung sowie die sich aus den Ansprüchen und der nachfolgenden Beschreibung ergebenden Aspekte, Merkmale und Verfahrensschritte der vorliegenden Erfindung können grundsätzlich unabhängig voneinander, aber auch in beliebiger Kombination bzw. Reihenfolge realisiert werden.

Weitere Aspekte, Vorteile, Merkmale und Eigenschaften der vorliegenden Erfindung ergeben sich aus den Ansprüchen und der nachfolgenden Beschreibung einer bevorzugten Ausführungsform anhand der Figuren. Es zeigt:
- Fig. 1: eine schematische Darstellung eines erfindungsgemäßen Systems;
- Fig. 2: eine schematische Darstellung der Abnahme einer Kapazität eines Akkus bei Lagerung;
- Fig. 3: eine schematische Darstellung einer Zunahme eines Innenwiderstands eines Akkus bei Lagerung;
- Fig. 4: eine schematische Darstellung einer Alterungsfunktion; und
- Fig. 5: eine schematische Darstellung eines Verfahrensablaufs bei der Bestimmung des Alterungszustands.

In den Figuren werden für gleiche, gleichartige oder ähnliche Bauteile und Komponenten dieselben Bezugszeichen verwendet, wobei entsprechende oder vergleichbare Eigenschaften oder Vorteile erreicht werden, auch wenn von einer wiederholten Beschreibung abgesehen wird.

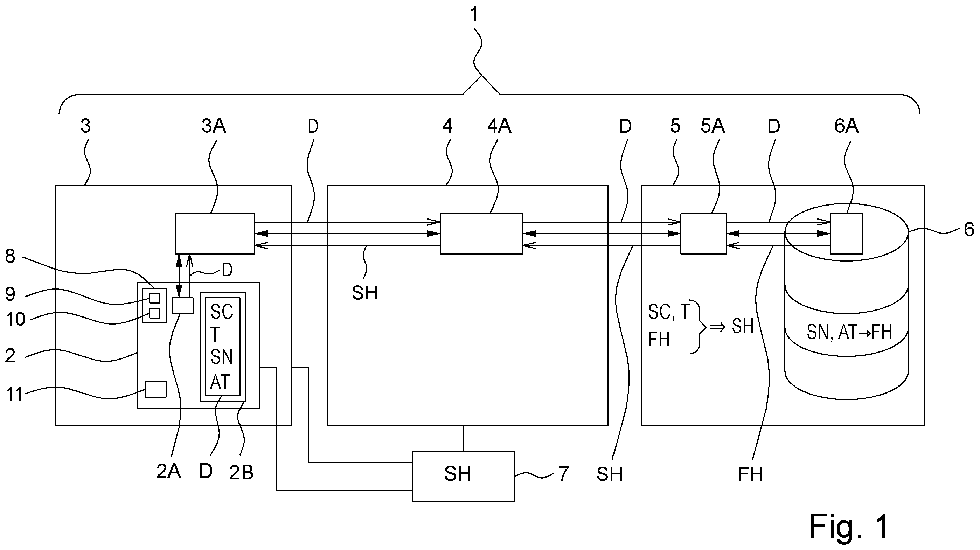

In Fig. 1 ist ein erfindungsgemäßes System 1 schematisch dargestellt. Das System 1 weist einen Akku 2 auf. Optional, jedoch bevorzugt, weist das System 1 zusätzlich zu dem Akku 2 ein Gerät 3, ein Kommunikationsgerät 4, eine Datenverarbeitungseinrichtung 5 und/oder eine Datenbank 6 auf.

Der Akku 2 ist vorzugsweise ein Lithium-Ionen-Akku. Vorzugsweise weist der Akku 2 mehrere, insbesondere parallel und/oder seriell verschaltete, Zellen auf. Die Nennkapazität bzw. maximale Kapazität K des Akkus 2 beträgt vorzugsweise mehr als 1.000 mAh und/oder weniger als 10.000 mAh. Die Ruhespannung des Akkus 2 beträgt vorzugsweise mehr als 5 V und/oder weniger als 50 V. Das Gewicht des Akkus 2 beträgt vorzugsweise weniger als 3 kg.

Vorzugsweise weist der Akku 2 einen Datenspeicher 2B auf. Insbesondere sind in dem Datenspeicher 2B (akkuspezifische) Daten D speicherbar bzw. gespeichert. Dies wird später noch genauer erläutert.

Der Akku 2 weist vorzugsweise eine eineindeutige Identifikationsnummer SN, insbesondere eine Seriennummer, auf. Die Identifikationsnummer SN ermöglicht vorzugsweise eine eindeutige Identifikation des jeweiligen Akkus 2 und insbesondere eine Unterscheidung des Akkus 2 von anderen Akkus 2 des gleichen Akkutyps AT. Die Identifikationsnummer SN ist vorzugsweise in dem Datenspeicher 2B gespeichert.

Der Akku 2 ist vorzugsweise dem Gerät 3 zugeordnet und/oder zum Betreiben des Geräts 3 ausgebildet. Insbesondere stellt der Akku 2 die zum Betreiben des Geräts 3 erforderliche Energie bereit.

Das Gerät 3 weist vorzugsweise den Akku 2 auf. Der Akku 2 ist vorzugsweise aus dem Gerät 3 entnehmbar.

Das Gerät 3 ist vorzugsweise ein Haushaltsgerät, insbesondere ein akkubetriebenes (Boden-)Reinigungsgerät, besonders bevorzugt ein Saugroboter, Staubsauger, Wischsauger, Fensterreiniger oder dergleichen. Grundsätzlich kann sich bei dem Gerät 3 jedoch um ein beliebiges akkubetriebenes Gerät bzw. Haushaltsgerät handeln.

Das Kommunikationsgerät 4 ist vorzugsweise ein mobiles Endgerät, ein Mobiltelefon, insbesondere Smartphone, ein Laptop, ein Tablet-Computer, ein PC oder dergleichen, insbesondere eines Nutzers bzw. Eigentümers des Geräts 3.

Die Datenverarbeitungseinrichtung 5 ist vorzugsweise eine Cloud, ein Server, ein Rechenzentrum oder dergleichen, insbesondere des Herstellers des Geräts 3. Vorzugsweise weist die Datenverarbeitungseinrichtung 5 die Datenbank 6 auf.

Der Akku 2 ist vorzugsweise mit dem Gerät 3, dem Kommunikationsgerät 4, der Datenverarbeitungseinrichtung 5 und/oder der Datenbank 6 datentechnisch verbunden bzw. verbindbar. Hierzu weist der Akku 2 vorzugsweise eine Kommunikationsschnittstelle 2A auf. Insbesondere ist der Akku 2 zur (Daten-)Kommunikation mit dem Gerät 3, dem Kommunikationsgerät 4, der Datenverarbeitungseinrichtung 5 und/oder der Datenbank 6 ausgebildet, insbesondere mittels der Kommunikationsschnittstelle 2A.

Das Gerät 3 ist vorzugsweise mit dem Akku 2, dem Kommunikationsgerät 4, der Datenverarbeitungseinrichtung 5 und/oder der Datenbank 6 datentechnisch verbunden bzw. verbindbar. Hierzu weist das Gerät 3 vorzugsweise eine Kommunikationsschnittstelle 3A auf. Insbesondere ist das Gerät 3 zur (Daten-)Kommunikation mit dem Akku 2, dem Kommunikationsgerät 4 der Datenverarbeitungseinrichtung 5, und/oder der Datenbank 6 ausgebildet, insbesondere mittels der Kommunikationsschnittstelle 3A.

Das Kommunikationsgerät 4 ist vorzugsweise mit dem Akku 2, dem Gerät 3, der Datenverarbeitungseinrichtung 5 und/oder der Datenbank 6 datentechnisch verbunden bzw. verbindbar. Hierzu weist das Kommunikationsgerät 4 vorzugsweise eine Kommunikationsschnittstelle 4A auf. Insbesondere ist das Kommunikationsgerät 4 zur (Daten-)Kommunikation mit dem Akku 2, dem Gerät 3, der Datenverarbeitungseinrichtung 5 und/oder der Datenbank 6 ausgebildet, insbesondere mittels der Kommunikationsschnittstelle 4A.

Das Kommunikationsgerät 4 weist vorzugsweise eine App zur Bedienung und/oder Steuerung des Geräts 3 auf. Das Kommunikationsgerät 4 bzw. die App ist vorzugsweise mit dem Gerät 3 koppelbar, insbesondere über die Kommunikationsschnittstellen 3A, 4A des Geräts 3 und des Kommunikationsgeräts 4. Vorzugsweise sind mittels der App Informationen über das Gerät 3 und/oder den Akku 2 abrufbar und/oder sind mit der App Einstellungen zum Betrieb des Geräts 3 vornehmbar bzw. veränderbar.

Die Datenverarbeitungseinrichtung 5 ist vorzugsweise mit dem Akku 2, dem Gerät 3, dem Kommunikationsgerät 4 und/oder der Datenbank 6 datentechnisch verbunden bzw. verbindbar. Hierzu weist die Datenverarbeitungseinrichtung 5 vorzugsweise eine Kommunikationsschnittstelle 5A auf. Insbesondere ist die Datenverarbeitungseinrichtung 5 zur (Daten-)Kommunikation mit dem Akku 2, dem Gerät 3, dem Kommunikationsgerät 4 und/oder der Datenbank 6 ausgebildet, insbesondere mittels der Kommunikationsschnittstelle 5A.

Die Datenbank 6 ist vorzugsweise mit dem Akku 2, dem Gerät 3, dem Kommunikationsgerät 4 und/oder der Datenverarbeitungseinrichtung 5 datentechnisch verbunden bzw. verbindbar. Hierzu weist die Datenbank 6 vorzugsweise eine Kommunikationsschnittstelle 6A auf. Insbesondere ist die Datenbank 6 zur (Daten-)Kommunikation mit dem Akku 2, dem Gerät 3, dem Kommunikationsgerät 4 und/oder der Datenverarbeitungseinrichtung 5 ausgebildet, insbesondere mittels der Kommunikationsschnittstelle 6A.

Die datentechnischen Verbindungen bzw. Kommunikationsverbindungen zwischen dem Akku 2, dem Gerät 3, dem Kommunikationsgerät 4, der Datenverarbeitungseinrichtung 5 und der Datenbank 6 bzw. deren Kommunikationsschnittstellen 2A-6A sind in Fig. 1 insbesondere durch Pfeile angedeutet.

Es ist bevorzugt, dass der Akku 2 nur mit dem Gerät 3 kommuniziert, das Gerät 3 nur mit dem Akku 2 und dem Kommunikationsgerät 4 kommuniziert und das Kommunikationsgerät 4 nur mit dem Gerät 3 und der Datenverarbeitungseinrichtung 5 bzw. Datenbank 6 kommuniziert. Grundsätzlich ist jedoch eine direkte Kommunikation zwischen allen Komponenten des Systems 1 möglich. Beispielsweise ist es möglich, dass der Akku 2 nicht nur mit dem Gerät 3, sondern alternativ oder zusätzlich direkt mit dem Kommunikationsgerät 4 und/oder der Datenverarbeitungseinrichtung 5 bzw. Datenbank 6 kommuniziert.

Vorzugsweise erfolgt die (Daten-)Kommunikation zwischen dem Akku 2, Gerät 3, Kommunikationsgerät 4, der Datenverarbeitungseinrichtung 5 und/oder der Datenbank 6 (jeweils) drahtlos, beispielsweise über NFC, Bluetooth, WLAN, Funk, das Mobilfunknetz und/oder das Internet.

Das System 1 weist vorzugsweise eine Benutzerschnittstelle 7 auf. Insbesondere weist der Akku 2, das Gerät 3 und/oder das Kommunikationsgerät 4 (jeweils) eine Benutzerschnittstelle 7 auf, wobei diese in diesem Fall gemeinsam die Benutzerschnittstelle 7 des Systems 1 bilden.

Die Benutzerschnittstelle 7 ist insbesondere eine Einrichtung, über die, insbesondere von einem Benutzer des Akkus 2 bzw. Geräts 3, Einstellungen zu dem Akku 2 und/oder Gerät 3 vornehmbar sind, über die der Akku 2 und/oder das Gerät 3 steuerbar bzw. bedienbar sind, und/oder über die Informationen zu dem Akku 2 und/oder dem Gerät 3 abrufbar sind. Insbesondere weist die Benutzerschnittstelle 7 eine mit dem Akku 2 bzw. Gerät 3 gekoppelte bzw. koppelbare App auf.

Es ist also besonders bevorzugt, dass das Kommunikationsgerät 4, insbesondere ein Smartphone oder dergleichen, eine App aufweist, über die Einstellungen zu dem Akku 2 und/oder Gerät 3 vornehmbar sind und Informationen zu dem Akku 2 und/oder dem Gerät 3 abrufbar sind. Zusätzlich zu der App kann die Benutzerschnittstelle 7 selbstverständlich weitere Einrichtungen, insbesondere Eingabeeinrichtungen, wie Tasten oder Knöpfe, und Ausgabeeinrichtungen wie Displays und/oder Lautsprecher, an dem Akku 2 und/oder Gerät 3 aufweisen.

Das System 1 ist zur Durchführung des hierin beschriebenen Verfahrens zum Betreiben des Systems 1 ausgebildet. Wenn daher nachfolgend ein Verfahrensschritt beschrieben wird, so ist das System 1 bzw. die Komponente des Systems 1, die den Verfahrensschritt durchführt, zur Durchführung des Verfahrensschritts ausgebildet, auch wenn dies nicht explizit erwähnt ist.

Das erfindungsgemäße Verfahren ist vorzugsweise ein computerimplementiertes Verfahren.

Das System 1 ist vorzugsweise ein System zur Datenverarbeitung, welches Mittel zur Ausführung des hierin beschriebenen Verfahrens aufweist. Vorzugsweise weist das System 1 einen oder mehrere Prozessoren auf, der/die so konfiguriert ist/sind, dass er/sie das Verfahren ausführt/ausführen.

Ferner betrifft die vorliegende Erfindung vorzugsweise ein Computerprogrammprodukt, umfassend Befehle, die bei der Ausführung des Programms durch einen Computer diesen veranlassen, das hierin beschriebene Verfahren auszuführen.

Schließlich betrifft die vorliegende Erfindung ebenfalls ein computerlesbares Speichermedium, umfassend das Computerprogrammprodukt und/oder Befehle, die bei der Ausführung durch einen Computer diesen veranlassen, das hierin beschriebene Verfahren auszuführen.

Bei dem erfindungsgemäßen Verfahren werden ein Ladezustand SC und/oder eine Temperatur T des Akkus 2 aufgezeichnet, indem der Ladezustand SC und/oder die Temperatur T zu mehreren Zeitpunkten automatisch gemessen und gespeichert werden. Die Zeitpunkte, zu denen der Ladezustand SC und/oder die Temperatur T gemessen und gespeichert werden, werden vorzugsweise ebenfalls aufgezeichnet bzw. erfasst und gespeichert. Dies kann beispielsweise dadurch erfolgen, dass die gemessenen und gespeicherten Ladezustände SC und/oder Temperaturen T jeweils mit einem Zeitstempel versehen werden.

Eine "Aufzeichnung" des Ladezustands SC und/oder der Temperatur T des Akkus 2 ist also insbesondere ein automatisches Messen und Speichern des Ladezustands SC und/oder der Temperatur T zu mehreren Zeitpunkten, insbesondere in regelmäßigen Abständen.

Vorzugsweise weist das System 1 bzw. der Akku 2 einen Zeitmesser, insbesondere eine Uhr bzw. eine Echtzeituhr (englisch Real-Time-Clock, kurz RTC) auf. Insbesondere können mittels des Zeitmessers die Zeitpunkte der Messung von Ladezustand SC und/oder Temperatur T erfasst werden. Ferner wird durch den Zeitmesser bzw. die Echtzeituhr vorzugsweise eine äquidistante und/oder zeitgestempelte Aufzeichnung ermöglicht.

Mittels der gespeicherten Ladezustände SC und/oder Temperaturen T wird ein kalendarischer Alterungszustand SH (englisch: State Of Health, kurz SOH) des Akkus 2 automatisch, insbesondere durch das System 1, bestimmt. Insbesondere wird durch den Alterungszustand SH die insbesondere kalendarische Alterung des Akkus 2 quantifiziert bzw. durch einen Wert oder eine Zahl dargestellt.

Die gemessenen Ladezustände SC und/oder Temperaturen T werden vorzugsweise in dem Datenspeicher 2B des Akkus 2 gespeichert. Grundsätzlich können die gemessenen Ladezustände SC und/oder Temperaturen T alternativ oder zusätzlich jedoch auch in dem Gerät 3, dem Kommunikationsgerät 4 und/oder der Datenverarbeitungseinrichtung 5 bzw. Datenbank 6 gespeichert werden.

Vorzugsweise weist das System 1, insbesondere der Akku 2 und/oder das Gerät 3, eine Messeinrichtung 8 zur Messung des Ladezustands SC und/oder der Temperatur T des Akkus 2 auf.

Des Weiteren weist das System 1, insbesondere der Akku 2 und/oder das Gerät 3, vorzugsweise eine Steuerung 11 zur Steuerung der Messeinrichtung 8 und/oder zur Steuerung der Aufzeichnung bzw. Messung und Speicherung des Ladezustands SC und/oder der Temperatur T auf. Insbesondere ist das System 1 bzw. der Akku 2 und/oder das Gerät 3 mittels der Steuerung 11 dazu ausgebildet, den Ladezustand SC und/oder die Temperatur T des Akkus 2 aufzuzeichnen.

Die Messeinrichtung 8 weist insbesondere einen oder mehrere Temperatursensoren 9 bzw. Thermometer zur Messung der Temperatur T des Akkus 2 auf. Alternativ oder zusätzlich weist die Messeinrichtung 8 vorzugsweise einen oder mehrere Spannungsmesser 10 zur Messung der Spannung, insbesondere Ruhespannung, des Akkus 2 und/oder einzelner Zellen des Akkus 2 auf.

Der Ladezustand SC ist insbesondere ein Maß für die dem Akku 2 (zu einem bestimmten Zeitpunkt) noch entnehmbare Ladungsmenge des Akkus 2.

Die Messung des Ladezustands SC kann beispielsweise über eine Messung der Ruhespannung des Akkus 2 oder dergleichen erfolgen. Insbesondere wird die Ruhespannung des Akkus 2 mittels des Spannungsmessers 10 gemessen.

Der Ladezustand SC (englisch: State Of Charge, kurz SOC) wird vorzugsweise als das Verhältnis zwischen der dem Akku 2 (zu einem bestimmten Zeitpunkt) entnehmbaren Ladungsmenge und der dem Akku 2 maximal entnehmbaren Ladungsmenge ausgedrückt bzw. repräsentiert und insbesondere in % angegeben.

Die dem Akku 2 maximal entnehmbare Ladungsmenge ist die Ladungsmenge, die dem Akku 2 entnehmbar ist, wenn er vollgeladen ist.

Somit ist der Ladezustand SC eines vollgeladenen Akkus 2 SC = 100 %. Entsprechend bedeutet ein Ladezustand SC von SC = 60 %, dass die dem Akku 2 entnehmbare Ladungsmenge 60 % der Ladungsmenge beträgt, die dem Akku 2 entnehmbar wäre, wenn er vollgeladen wäre.

Alternativ oder zusätzlich kann der Ladezustand SC jedoch auch durch die Ruhespannung des Akkus 2 ausgedrückt bzw. repräsentiert werden. Insbesondere ist die Ruhespannung äquivalent zu dem Verhältnis zwischen der dem Akku 2 (zu einem bestimmten Zeitpunkt) entnehmbaren Ladungsmenge und der dem Akku 2 maximal entnehmbaren Ladungsmenge bzw. kann die Ruhespannung in dieses Verhältnis umgerechnet werden.

Die Ruhespannung des Akkus 2, auch als Leerlaufspannung bezeichnet, ist insbesondere die Spannung an einer Ausgangsseite des Akkus 2, wenn kein Verbraucher an den Akku 2 angeschlossen ist bzw. mit dem Akku 2 kein (externer) Verbraucher, insbesondere das Gerät 3, betrieben wird. Die Ruhespannung des Akkus 2 ist insbesondere die Spannung an der Ausgangsseite des Akkus 2, wenn der Akku 2 deaktiviert ist.

Der Akku 2 ist insbesondere deaktiviert, wenn der Akku 2 bzw. das Gerät 3 ausgeschaltet ist oder sich in einem Standby-Modus befindet und/oder wenn der Akku 2 aus dem Gerät 3 entnommen ist.

Vorzugsweise wird der Ladezustand SC, insbesondere automatisch, ermittelt bzw. gemessen, wenn bzw. bevor der Akku 2 und/oder das Gerät 3 deaktiviert werden/wird.

Die Messung des Ladezustands SC erfolgt insbesondere durch eine Messung der Ruhespannung des Akkus 2. Es ist jedoch auch möglich, dass der aktuelle Ladezustand SC des Akkus 2 fortlaufend, regelmäßig und/oder kontinuierlich gemessen oder überwacht wird und/oder jeweils automatisch gespeichert ist, insbesondere in dem Datenspeicher 2B des Akkus 2, so dass eine Messung bzw. Bestimmung des Ladezustands SC einfach durch Abruf des gespeicherten Ladezustands SC erfolgt.

Als Maß für den kalendarischen Alterungszustand SH wird vorzugsweise eine Abnahme der Kapazität K des Akkus 2 gegenüber einer Nennkapazität und/oder eine Zunahme eines Innenwiderstands R des Akkus 2 gegenüber einem Nennwiderstand bestimmt.

Die Kapazität K des Akkus 2 ist vorzugsweise die dem Akku 2 maximal entnehmbare Ladungsmenge, also die Ladungsmenge, die dem Akku 2 entnehmbar ist, wenn er vollgeladen ist. Die Kapazität K des Akkus 2 nimmt vorzugsweise mit fortschreitender Alterung des Akkus 2 ab.

Insbesondere kann sich daher die (aktuelle) Kapazität des Akkus 2 von einer Nennkapazität des Akkus 2 unterscheiden. Die Nennkapazität des Akkus 2 ist insbesondere die Kapazität des Akkus 2 ohne Verluste durch Alterung.

Wenn die Kapazität K des Akkus 2 durch Alterung abgenommen hat, lässt sich dem bis zur Kapazität K vollgeladenen Akku 2 weniger Ladungsmenge entnehmen als einem bis zur Nennkapazität vollgeladenen Akku 2 entnehmbar wären. Wenn die Kapazität beispielsweise 80 % der Nennkapazität beträgt, so lassen sich dem Akku 2, selbst wenn er vollgeladen wird, nur noch maximal 80 % der Ladungsmenge entnehmen, die einem bis zur Nennkapazität vollgeladenen Akku 2 entnehmbar wären.

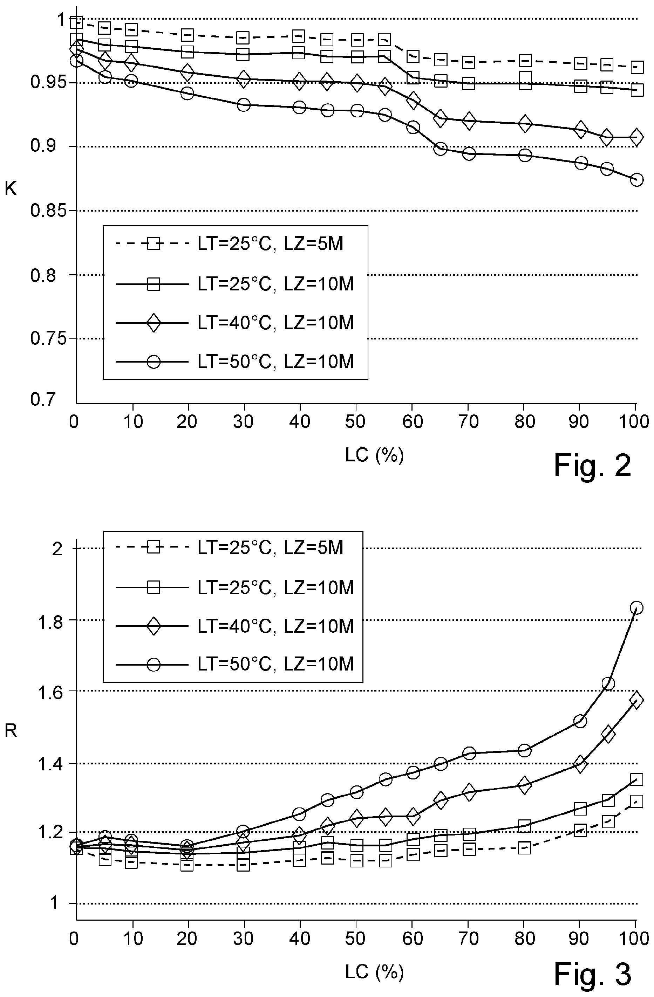

Die Fig. 2 zeigt ein Diagramm, in dem die (gemessene) Kapazität K des Akkus 2 nach Lagerung für einen bestimmten Lagerzeitraum LZ bei einer bestimmten Lagertemperatur LT aufgetragen ist gegen den Lagerladezustand LC des jeweiligen Akkus 2.

Die Kapazität K ist in Fig. 2 auf die Kapazität K des Akkus 2 vor bzw. bei Beginn der Lagerung normiert, sodass ein Wert von K = 1 bedeutet, dass die Kapazität K am Ende der Lagerung gleich der Kapazität K bei Beginn der Lagerung ist, während ein Wert von K < 1 bedeutet, dass die Kapazität K des Akkus 2 durch die bzw. während der Lagerung abgenommen hat. Beispielsweise beträgt bei K = 0,8 die Kapazität K nach der Lagerung nur noch 80 % der Kapazität K zu Beginn der Lagerung.

In der Legende von Fig. 2 ist angegeben, bei welcher Lagertemperatur LT (im Darstellungsbeispiel 25°C, 40°C und 50°C) der Akku 2 jeweils gelagert wurde.

Bei den in der Legende mit LZ = 10M gekennzeichneten Kurven wurde der Akku 2 jeweils für zehn Monate gelagert, sodass der jeweilige Wert Q die (relative) Kapazität K des Akkus 2 nach Lagerung für zehn Monate repräsentiert. Bei der in der Legende mit LZ=5M gekennzeichneten Kurve wurde der Akku 2 für fünf Monate (bei einer Lagertemperatur LT von 25°C) gelagert, sodass der jeweilige Wert Q die (relative) Kapazität K des Akkus 2 nach Lagerung für fünf Monate repräsentiert.

Aus Fig. 2 ist ersichtlich, dass die Kapazität K eines Akkus 2 bei Lagerung abnimmt. Dabei ist die Kapazitätsabnahme um so stärker, je höher der Lagerladezustand LC ist und je höher die Lagertemperatur LT ist.

Die Fig. 3 zeigt ein Diagramm, in dem der (gemessene) Innenwiderstand R des Akkus 2 nach Lagerung für einen bestimmten Lagerzeitraum LZ bei einer bestimmten Lagertemperatur LT aufgetragen ist gegen den Lagerladezustand LC des jeweiligen Akkus 2.

Der Innenwiderstand R ist in Fig. 2 auf den Innenwiderstand R des Akkus 2 vor bzw. bei Beginn der Lagerung normiert, sodass ein Wert von R = 1 bedeutet, dass die Kapazität K am Ende der Lagerung gleich dem Innenwiderstand R bei Beginn der Lagerung ist, während ein Wert von R > 1 bedeutet, dass der Innenwiderstand R des Akkus 2 durch die bzw. während der Lagerung zugenommen hat. Beispielsweise beträgt bei R = 1,6 der Innenwiderstand R das 1,6-fache bzw. 160 % des Innenwiderstands R zu Beginn der Lagerung.

In der Legende von Fig. 3 ist angegeben, bei welcher Lagertemperatur LT (im Darstellungsbeispiel 25°C, 40°C und 50°C) der Akku 2 jeweils gelagert wurde.

Bei den in der Legende mit LZ=10M gekennzeichneten Kurven wurde der Akku 2 jeweils für zehn Monate gelagert, sodass der jeweilige Wert R den (relativen) Innenwiderstand R des Akkus 2 nach Lagerung für zehn Monate repräsentiert. Bei der in der Legende mit LZ=5M gekennzeichneten Kurve wurde der Akku 2 für fünf Monate (bei einer Lagertemperatur LT von 25°C) gelagert, sodass der jeweilige Wert R den (relativen) Innenwiderstand R des Akkus 2 nach Lagerung für fünf Monate repräsentiert.

Aus Fig. 3 ist ersichtlich, dass der Innenwiderstand R eines Akkus 2 bei Lagerung abnimmt. Dabei ist die Innenwiderstandszunahme um so stärker, je höher der Lagerladezustand LC ist und je höher die Lagertemperatur LT ist.

Die Darstellungen in Fig. 2 und 3 sind rein exemplarisch für einen bestimmten Akkutyp AT und sollen beispielhaft die Kapazitätsabnahme bzw. Innenwiderstandszunahme bei bzw. durch Lagerung verdeutlichen. Für andere Akkutypen AT können sich also andere Kurvenverläufe vergeben.

Aus Fig. 2 und 3 ist entnehmbar, dass ein Akku 2 umso schneller altert, je höher seine Lagertemperatur LT ist und je höher sein Lagerladezustand LC ist, da mit steigender Lagertemperatur LT und steigendem Lagerladezustand LC die Kapazität K schneller abnimmt und/oder der Innenwiderstand R schneller ansteigt.

Ein "Lagerladezustand" im Sinne der vorliegenden Erfindung ist insbesondere ein Ladezustand SC während bzw. zu Beginn einer Lagerung des Akkus 2. Dabei ist es möglich, dass sich der Ladezustand SC des Akkus 2 während der Lagerung verringert, beispielsweise durch eine Selbstentladung des Akkus 2.

Eine "Lagertemperatur" im Sinne der vorliegenden Erfindung ist insbesondere eine Temperatur T des Akkus 2 bzw. seiner Umgebung während bzw. zu Beginn einer Lagerung des Akkus 2.

Eine "Lagerung" des Akkus 2 ist insbesondere ein Zustand des Akkus 2, in dem der Akku 2 nicht verwendet wird und/oder das Gerät 3 nicht mit dem Akku 2 betrieben wird. Bei Lagerung des Akkus 2 kann der Akku 2 in das Gerät 3 eingesetzt sein oder aus dem Gerät 3 entnommen sein. Insbesondere liegt eine Lagerung des Akkus 2 vor, wenn das Gerät 3 nicht mit dem Akku 2 betrieben wird und/oder der Akku 2 bzw. das Gerät 3 deaktiviert ist, insbesondere ausgeschaltet ist oder sich in einem Standby-Modus befindet.

Eine "Selbstentladung" des Systems 1 ist insbesondere eine Entladung des Systems 1 bzw. des Akkus 2, die bei Lagerung des Akkus 2 erfolgt und/oder ohne dass das Gerät 3 mit dem Akku 2 betrieben wird und/oder wenn das Gerät 3 und/oder der Akku 2 deaktiviert sind/ist, insbesondere ausgeschaltet sind/ist oder sich in einem Standby-Modus befinden/befindet.

Vorzugsweise wird zur Bestimmung des kalendarischen Alterungszustands SH eine Alterungsfunktion FH verwendet.

Die Alterungsfunktion FH wird insbesondere empirisch ermittelt. Vorzugsweise ist die Alterungsfunktion FH akkutypspezifisch. Vorzugsweise unterscheiden sich die Alterungsfunktionen FH unterschiedlicher Akkutypen AT.

Der Akkutyp AT umfasst insbesondere einen Zelltyp des Akkus 2, also eine Information darüber, welche Art und/oder Anzahl von Zellen der Akku 2 aufweist. Unterschiedliche Akkus 2 bzw. Zellen können sich beispielsweise in ihrer Kapazität K, Ruhespannung, Verschaltung (beispielsweise Parallelschaltung oder Serienschaltung) und/oder Zellchemie bzw. Zelltyp (beispielsweise Lithium-Eisen-Phosphat (LFP), Lithium-Nickel-Mangan-Cobaltoxid (NMC), Lithium-Nickel-Cobalt-Aluminium-Oxid (NCA) oder Lithium-Cobalt(III)-Oxid (LCO)) unterscheiden.

Die Alterungsfunktion FH ordnet verschiedenen Lagerladezuständen LC und/oder Lagertemperaturen LT eines Akkutyps AT jeweils einen kalendarischen Alterungszustand SH nach einer Lagerung für einen oder mehrere definierte Zeiträume zu.

Der definierte Zeitraum bzw. die definierten Zeiträume werden nachfolgend auch als Lagerzeitraum LZ bzw. Lagerzeiträume LZ bezeichnet.

Die Alterungsfunktion FH ist insbesondere eine diskrete Funktion, also eine Funktion, bei der diskreten bzw. abzählbar vielen Lagerladezuständen LC und/oder Lagertemperaturen LT jeweils ein (kalendarischer) Alterungszustand SH zugeordnet ist. Die Alterungsfunktion FH liegt vorzugsweise in Form einer Tabelle bzw. Look-up-Table vor. Hier sind jedoch auch andere Lösungen möglich, beispielsweise dass die Alterungsfunktion FH in Form eines Diagramms, einer Funktionsgleichung oder einer sonstigen Zuordnungsvorschrift vorliegt.

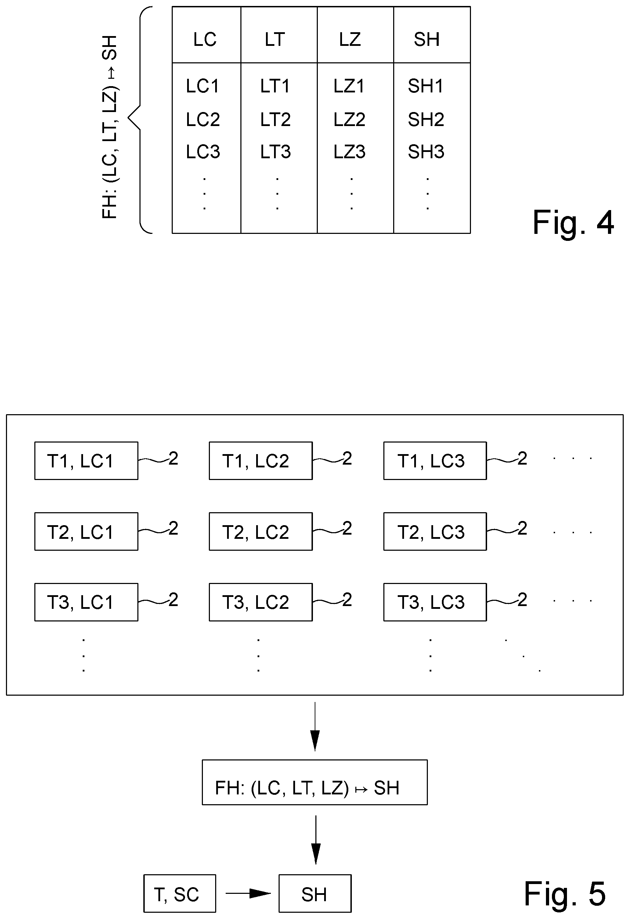

Die Fig. 4 zeigt beispielhaft eine Alterungsfunktion FH in Tabellenform. Gemäß Fig. 4 wird jeweils einer Wertekombination von Lagerladezustand LC, Lagertemperatur LT und Lagerzeit LZ ein zugehöriger Alterungszustand SH zugeordnet. Beispielsweise ist der Kombination von Lagerladezustand LC1, Lagertemperatur LT1 und Lagerladezeitraum LZ1 der Alterungszustand SH1 zugeordnet usw.

Bei Verwendung der Alterungsfunktion FH zur Bestimmung des Alterungszustands SH kann auf eine direkte Messung des Alterungszustands SH des Akkus 2 verzichtet werden. Es ist nämlich erfindungsgemäß vorgesehen, den Alterungszustand SH des Akkus 2 statt durch eine direkte Messung indirekt zu ermitteln, indem der Ladezustand SC und/oder die Temperatur T des Akkus 2 aufgezeichnet werden und anhand einer Alterungsfunktion FH auf Basis der aufgezeichneten Ladezustände SC und/oder Temperaturen T, insbesondere gemittelten Werte der aufgezeichneten Ladezustände SC und/oder Temperatur T, der Alterungszustand SH ermittelt wird.

Zur Ermittlung der Alterungsfunktion FH werden insbesondere Messreihen durchgeführt, bei denen mehrere Akkus 2 des Akkutyps AT mit verschiedenen Lagerladezuständen LC und/oder bei verschiedenen Lagertemperaturen LT gelagert werden. Die Lagerung erfolgt insbesondere für einen oder mehrere Lagerzeiträume LZ.

Es ist also bevorzugt, dass zur Ermittlung der Alterungsfunktion FH eines bestimmten Akkutyps AT mehrere (baugleiche) Akkus 2 des Akkutyps AT gelagert werden. Dabei werden einige Akkus 2 mit verschiedenen Lagerladezuständen LC, aber bei der gleichen Lagertemperatur LT gelagert. Des Weiteren werden mehrere Akkus 2 bei der gleichen Lagertemperatur LT, aber mit verschiedenen Lagerladezuständen LC gelagert. Dies erfolgt vorzugsweise für mindestens einen definierten Lagerzeitraum LZ, beispielsweise mehrere Tage, Wochen oder Monate. Es ist jedoch auch möglich, dass die Lagerung für mehrere definierte Lagerzeiträume LZ erfolgt bzw. der Alterungszustand LC zu mehreren Zeitpunkten während eines Lagerzeitraums LZ gemessen wird.

Die Messung des Alterungszustands SH erfolgt insbesondere durch eine Messung des Innenwiderstands R und/oder der Kapazität K des Akkus 2. Die Abnahme der Kapazität K gegenüber einer Nennkapazität und/oder die Zunahme des Innenwiderstands R gegenüber einem Nennwiderstand dienen dann als Maß für den kalendarischen Alterungszustand SH des Akkus 2.

Anhand der Messreihen kann ermittelt werden, wie stark ein Akku 2 (eines bestimmten Akkutyps AT) in einer bestimmten Zeit altert, wenn er bei einer bestimmten Lagertemperatur LT und/oder mit einem bestimmten Lagerladezustand LC gelagert wird.

Anschließend wird auf Basis der Messreihen bzw. des gemessenen Alterungszustands SH die Alterungsfunktion FH erstellt. Die Alterungsfunktion FH gibt also insbesondere an, wie sich der kalendarische Alterungszustand SH eines Akkus 2 bzw. eines bestimmten Akkutyps AT ändert, wenn er bei einer bestimmten Lagertemperatur LT, mit einem bestimmten Lagerzustand LC und für einen bestimmten Lagerzeitraum LZ gelagert wird.

Vorzugsweise werden für verschiedene Akkutypen AT Messreihen zur Ermittlung der Alterungsfunktion FH für den jeweiligen Akkutyp AT durchgeführt.

Die ermittelte Alterungsfunktion FH bzw. die ermittelten Alterungsfunktionen FH werden vorzugsweise (elektronisch) gespeichert, insbesondere in der Datenbank 6. Vorzugsweise weist die Datenbank 6 mehrere Alterungsfunktionen FH auf, die jeweils einem Akkutyp AT zugeordnet bzw. für einen Akkutyp AT spezifisch sind. Insbesondere sind also für verschiedene Akkutypen AT Alterungsfunktionen FH in der Datenbank 6 gespeichert. Grundsätzlich ist es jedoch auch möglich, die Alterungsfunktion(en) FH in dem Akku 2, insbesondere dessen Datenspeicher 2B, dem Gerät 3 und/oder dem Kommunikationsgerät 4 zu speichern.

Dem Akku 2 ist vorzugsweise eine Information zu dem Akkutyp AT zugeordnet. Mittels dieser Information wird bei der Bestimmung des kalendarischen Alterungszustands FH des Akkus 2 vorzugsweise die dem Akkutyp AT des Akkus 2 entsprechende Alterungsfunktion FH ausgewählt.

Das grundlegende Vorgehen zur Bestimmung des kalendarischen Alterungszustands SH ist insbesondere in Fig. 5 schematisch dargestellt bzw. zusammengefasst: Zunächst werden mehrere Akkus 2 des gleichen Akkutyps AT bei unterschiedlichen Lagertemperaturen T1, T2, T3, ... und/oder unterschiedlichen Lagerladezuständen LC1, LC2, LC3, ... für einen Lagerzeitraum LZ gelagert. Am Ende des Lagerzeitraums LZ werden/wird der Innenwiderstand R und/oder die Kapazität K der Akkus 2 jeweils gemessen bzw. der Alterungszustand SH der Akkus 2 jeweils bestimmt. Anhand dieser Informationen wird dann die Alterungsfunktion FH erstellt, die dem Lagerzustand LC, der Lagertemperatur LT und/oder dem Lagerzeitraum LZ jeweils einen (kalendarischen) Alterungszustand SH zuordnet. Beim Betrieb des Systems 1 bzw. Akkus 2 bzw. Geräts 3 werden dann die Temperatur T und/oder der Ladezustand SC des Akkus 2 aufgezeichnet. Anhand der aufgezeichneten insbesondere gemittelten Temperaturen T und/oder Ladezustände SC wird dann unter Zuhilfenahme der Alterungsfunktion FH der jeweils aktuelle Alterungszustand SH des Akkus 2 bestimmt.

Einzelne Schritte bei der Bestimmung des kalendarischen Alterungszustands SH werden dabei vorzugsweise auf verschiedenen Komponenten des Systems 1 durchgeführt, wie nachfolgend näher erläutert:
Zunächst wird - insbesondere separat von der Nutzung bzw. Betrieb des Systems 1, Akkus 2 und/oder Geräts 3 wie voranstehend beschrieben - die Alterungsfunktion FH anhand von Messreihen ermittelt.

Beim Betrieb des Systems 1 bzw. Akkus 2 bzw. Geräts 3 werden vorzugsweise der Ladezustand SC und/oder die Temperatur T des Akkus 2 aufgezeichnet, insbesondere durch Messung und Speicherung des Ladezustands SC und/oder der Temperatur T in regelmäßigen Abständen. Vorzugsweise werden die Ladezustände SC und/oder Temperaturen T in dem Datenspeicher 2B gespeichert. Alternativ oder zusätzlich können die Ladezustände SC und/oder Temperaturen T jedoch auch in dem Gerät 3, Kommunikationsgerät 4 und/oder der Datenbank 6 gespeichert werden.

Es kann vorgesehen sein, (ältere bzw. länger zurückliegende) gespeicherte Ladezustände SC und/oder Temperaturen T aus dem Datenspeicher 2B zu löschen und/oder einzelne gespeicherte Ladezustände SC und/oder Temperaturen T zu löschen, wenn sie identisch oder sehr ähnlich zu zuvor oder nachfolgend gemessenen Ladezuständen SC bzw. Temperaturen T sind und/oder wenn sie von dem Akku 2 an das Gerät 3, das Kommunikationsgerät 4 und/oder die Datenverarbeitungseinrichtung 5 bzw. Datenbank 6 übertragen wurden.

Der Akku 2 weist vorzugsweise akkuspezifische Daten D auf. Akkuspezifische Daten D sind insbesondere solche Daten D, die den Akku 2 von anderen baugleichen Akkus 2 bzw. anderen Akkus des gleichen Akkutyps AT unterscheiden. Die Daten D sind bzw. werden vorzugsweise in dem Akku 2 bzw. Datenspeicher 2B gespeichert, können alternativ oder zusätzlich aber auch in dem Gerät 3, dem Kommunikationsgerät 4 und/oder der Datenbank 6 gespeichert sein.

Der Ladezustand SC, die Temperatur T, die eineindeutige Identifikationsnummer SN und/oder der Akkutyp AT stellen insbesondere akkuspezifische Daten D dar.

Nach einer Messung und Speicherung von Ladezustand SC und/oder Temperatur T werden die Daten D, insbesondere also die gemessenen und gespeicherten Werte von Ladezustand SC und/oder Temperatur T und vorzugsweise die Identifikationsnummer SN und/oder der Akkutyp AT, vorzugsweise übertragen, insbesondere von dem Akku 2 an das Gerät 3, das Kommunikationsgerät 4 und/oder die Datenverarbeitungseinrichtung 5 bzw. Datenbank 6. Dies erfolgt insbesondere mittels der jeweiligen Kommunikationsschnittstellen 2A-6A.

Vorzugsweise übermittelt das Gerät 3 die von dem Akku 2 empfangenen Daten D weiter an das Kommunikationsgerät 4. Das Kommunikationsgerät 4 übermittelt die Daten D vorzugsweise an die Datenverarbeitungseinrichtung 5 bzw. Datenbank 6. Die Übermittlung von Daten ist insbesondere in Fig. 1 durch entsprechende Pfeile symbolisiert.

Die Bestimmung des Alterungszustands SH erfolgt vorzugsweise mittels der Datenverarbeitungseinrichtung 5. Hierzu wählt die Datenverarbeitungseinrichtung 5 vorzugsweise auf Basis der Identifikationsnummer SN und/oder des Akkutyps AT die dem Akku 2 entsprechende bzw. zugehörige Alterungsfunktion FH aus. Vorzugsweise wird dann anhand der aufgezeichneten Ladezustände SC und/oder Temperaturen T und der ausgewählten Alterungsfunktion FH der (kalendarische) Alterungszustand SH bestimmt. Insbesondere werden dabei die Zeiträume, für die der Akku 2 bei einer bestimmten Temperatur T und/oder mit einem bestimmten Ladezustands SC gelagert wurde, berücksichtigt.

Vorzugsweise werden/wird ausgehend von den aufgezeichneten Ladezuständen SC und/oder Temperaturen T zunächst ein oder mehrere Lagerladezustände LC und/oder eine oder mehrere Lagertemperaturen LT des Akkus 2 ermittelt. Beispielsweise kann ein Lagerladezustand LC bzw. eine Lagertemperatur LT durch einen Mittelwert oder Durchschnittswert von aufgezeichneten Ladezuständen SC bzw. Temperaturen T gebildet sein. Insbesondere ist es möglich, einzelne gemessene Ladezustände SC bzw. Temperaturen T bei der Bildung des Mittelwerts bzw. Durchschnittswerts unterschiedlich zu gewichten. Hierdurch können beispielsweise unterschiedliche Zeitabstände zwischen den Messungen, besonders hohe oder niedrige Ladeszutände SC bzw. Temperaturen T und/oder Lade- bzw. Entladevorgänge, die zum Zeitpunkt einer Messung von Ladezustand SC bzw. Temperatur T stattgefunden haben, berücksichtigt werden.

Auf Basis der ermittelten Lagerladezustände LC und/oder Lagertemperaturen LT wird dann mittels der ausgewählten Alterungsfunktion FH der (kalendarische) Alterungszustand SH bestimmt. Dies erfolgt insbesondere, indem als Alterungszustand SH derjenige Alterungszustand SH ausgewählt bzw. bestimmt ist, der in der Alterungsfunktion FH dem ermittelten Lagerladezustand LC und/oder der ermittelten Lagerladetemperatur LT zugeordnet ist.

Es kann auch vorgesehen sein, ausgehend von einem zuletzt bestimmten bzw. gespeicherten Alterungszustand SH nur die zusätzliche Alterung bzw. Veränderung des Alterungszustands SH zu bestimmen, die nach dem zuletzt bestimmten bzw. gespeicherten Alterungszustand SH erfolgt ist.

Der bestimmte Alterungszustand SH wird vorzugsweise in der Datenverarbeitungseinrichtung 5 bzw. Datenbank 6 gespeichert.

Ferner ist es bevorzugt, dass der bestimmte Alterungszustand SH alternativ oder zusätzlich an das Kommunikationsgerät 4, das Gerät 3 und/oder den Akku 2 übermittelt und dort jeweils gespeichert wird. Die Übermittlung erfolgt wiederum bevorzugt mittels der Kommunikationsschnittstellen 2A-6A.

Grundsätzlich sind hier jedoch auch andere Lösungen möglich. Insbesondere kann/können die Alterungsfunktion(en) FH, die in dem beschriebenen besonders bevorzugten Ausführungsbeispiel in der Datenbank 6 gespeichert ist/sind, auch auf dem Akku 2, dem Gerät 3 und/oder dem Kommunikationsgerät 4 gespeichert sein.

Es ist auch möglich, dass die Bestimmung des Alterungszustands SH nicht oder nicht vollständig mittels der Datenverarbeitungseinrichtung 5, sondern alternativ oder zusätzlich mittels des Akkus 2, des Geräts 3 und/oder des Kommunikationsgeräts 4 erfolgt. Dabei können auch einzelne Schritte der Bestimmung des Alterungszustands SH auf verschiedenen Komponenten des Systems 1 durchgeführt werden.

Wie bereits erläutert, werden/wird der Ladezustand SC und/oder die Temperatur T vorzugsweise in regelmäßigen Abständen gemessen und gespeichert. Beispielsweise kann die Messung und Speicherung des Ladezustands SC und/oder der Temperatur T in Abständen von einem oder mehreren Tagen, einer oder mehreren Wochen oder einem oder mehreren Monaten erfolgen.

Vorzugsweise werden die Abstände, in denen Ladezustand SC und/oder Temperatur T gemessen werden, angepasst. Die Anpassung erfolgt insbesondere in Abhängigkeit von einer Nutzung des Akkus 2 und/oder in Abhängigkeit von den gemessenen Ladezuständen SC und/oder Temperaturen T des Akkus 2. Vorzugsweise erfolgt die Anpassung automatisch und/oder mittels der Steuerung 11.

Beispielsweise ist es bevorzugt, dass die Abstände kürzer gewählt werden, je höher der Ladezustand SC des Akkus 2 ist und/oder je höher die Temperatur T des Akkus 2 ist. Es hat sich nämlich gezeigt, dass bei höherem Ladezustand SC und/oder Lagerladezustand LC und bei höherer Temperatur T bzw. Lagertemperatur LT des Akkus 2 die Alterung des Akkus 2 jeweils stärker ausgeprägt ist, was insbesondere auch in Fig. 2 und 3 beispielhaft dargestellt ist. Eine entsprechende Anpassung der Abstände, zu denen der Ladezustand SC und/oder die Temperatur T gemessen werden, ist daher einer verbesserten Genauigkeit bei der Bestimmung des kalendarischen Alterungszustands SH zuträglich.

Gemäß einer bevorzugten Variante ist vorgesehen, dass über einen kurzen Zeitraum, beispielweise einen oder zwei Tage, die Abstände kurz gewählt werden bzw. mehrere Messungen von Temperatur T und/oder Ladezustand SC durchgeführt werden. Beispielweise können die Messungen in Abständen von mehreren Stunden, insbesondere mindestens oder mehr als zwei Stunden und/oder höchstens oder weniger als zwölf Stunden, besonders bevorzugt von etwa sechs Stunden, durchgeführt werden und/oder können innerhalb des Zeitraums mindestens zwei und/oder höchstens sechs, besonders bevorzugt etwa vier, Messungen durchgeführt werden. Falls sich die bei diesen Messungen innerhalb des kurzen Zeitraums gemessenen Werte sich nur geringfügig unterscheiden bzw. die Abweichung der Werte unterhalb eines vordefinierten Grenzwerts liegt, werden die Messungen vorzugsweise für einen längeren Zeitraum, beispielsweise mehrere Tage, insbesondere etwa fünf Tage, ausgesetzt. Anschließend wird der Vorgang vorzugsweise wiederholt, also wieder über einen kurzen Zeitraum Messungen in kurzen Abständen durchgeführt und danach, falls nur geringe Abweichungen bestehen, für einen längeren Zeitraum keine Messungen durchgeführt.

Vorzugsweise wird bei den Messungen von Temperatur T und/oder Ladezustand SC die Uhrzeit des Messzeitpunkts erfasst bzw. abgespeichert. Insbesondere erfolgt dies mittels des Zeitmessers.

Bei starker bzw. häufiger Nutzung, also insbesondere bei einer Vielzahl von Lade-und Entladevorgängen des Akkus 2, bei hohen Entladungstiefen und/oder bei hohen Lade- und/oder Entladeströmen, nimmt die zyklische Alterung des Akkus 2 stärker zu, sodass die kalendarische Alterung weniger zu der Gesamtalterung beträgt. Dies kann beispielsweise berücksichtigt werden, indem die Abstände der Messung von Ladezustand SC und/oder Temperatur T vergrößert werden.

Ferner kann es vorteilhaft sein, mit sinkendem Ladezustand SC die Abstände der Messung und Speicherung von Ladezustand SC und/oder Temperatur T zu vergrößern. Dies erfolgt insbesondere automatisch und/oder mittels der Steuerung 11. Bei Erreichen oder Unterschreiten eines unteren Grenzwerts des Ladezustands SC werden vorzugsweise die zeitlichen Abstände der Messung von Ladezustand SC und/oder Temperatur T vergrößert oder wird die Aufzeichnung des Ladezustands SC und/oder der Temperatur T vorzugsweise beendet oder unterbrochen. Da durch die Aufzeichnung von Ladezustand SC und/oder Temperatur T der Akku 2 (geringfügig) entladen wird, kann durch diese Maßnahme verhindert werden, dass sich der Akku 2 weiter entlädt bzw. kann eine Tiefentladung der Akku 2 und somit eine Beschädigung oder Zerstörung des Akkus 2 verhindert werden.

Vorzugsweise erfolgt auch nach einer solchen Anpassung wieder eine Messung und Speicherung von Ladezustand SC und/oder Temperatur T in regelmäßigen Abständen. Es ist also bevorzugt, dass die Messung von Ladezustand SC und/oder Temperatur T in regelmäßigen Abständen erfolgt, wobei die Größe der Abstände je nach Nutzung des Akkus 2, gemessenen Ladezuständen SC und/oder Temperaturen T des Akkus 2 größer oder kleiner gewählt werden.

Vorzugsweise wird (automatisch) erfasst, wenn die Temperatur T einen vordefinierten Temperaturgrenzwert erreicht, unterschreitet oder überschreitet. Das Erreichen Unterschreiten oder Überschreiten des Temperaturgrenzwerts wird vorzugsweise aufgezeichnet bzw. protokolliert. Insbesondere werden/wird der Ladezustand SC und/oder die Temperatur T gemessen und gespeichert, wenn ein vordefinierter Temperaturgrenzwert erreicht, unterschritten oder überschritten wird, insbesondere zusätzlich zu der Aufzeichnung bzw. Messung und Speicherung von Ladezustand SC und/oder Temperatur T in regelmäßigen Abständen. Hierdurch können kritische Ereignisse, insbesondere kritische thermische Ereignisse, erfasst werden, die zu einer besonders starken kalendarischen Alterung des Akkus 2 führen. Die Genauigkeit bei der Bestimmung des kalendarischen Alterungszustands SH kann somit verbessert werden.

Ferner besteht die Möglichkeit, bei Erfassen eines solchen kritischen Ereignisses eine Mitteilung auszugeben. Hierdurch kann der Nutzer informiert werden. Insbesondere kann die Mitteilung eine Empfehlung bzw. Anweisung enthalten, beispielsweise dass der Akku 2 bei einer höheren oder niedrigeren Temperatur T gelagert werden sollte oder extreme Temperaturen, insbesondere Temperaturen ober- oder unterhalb eines vordefinierten Temperaturgrenzwerts, bei der Lagerung vermieden werden sollten.

Zur Erfassung des Erreichens, Überschreitens oder Unterschreitens eines Temperaturgrenzwerts kann das System 1, insbesondere der Akku 2 und/oder das Gerät 3, eine Schaltung, insbesondere Komparator-Schaltung, aufweisen, die das entsprechende Ereignis erfasst und daraufhin eine Messung und Speicherung von Ladezustand SC und/oder Temperatur T veranlasst. Die Schaltung kann insbesondere den bzw. die Temperatursensoren 9 aufweisen oder damit gekoppelt sein.

Vorzugsweise löst die Schaltung bzw. Komparator-Schaltung bei Erreichen, Unterschreiten oder Überschreiten des vordefinierten Temperaturgrenzwerts aus, sodass ein Mikrocontroller aufgeweckt wird und die Messung und Speicherung des Ladezustands SC und/oder der Temperatur T durchführt. Insbesondere ist die Schaltung bzw. Komparator-Schaltung Teil einer Schutzelektronik bzw. eines Batteriemanagementsystems, die bzw. das dazu ausgebildet ist, ein Laden des Akkus 2 zu blockieren, wenn eine Mindestruhespannung des Akkus 2 erreicht oder unterschritten wird.

Die Bestimmung des Alterungszustands SH wird vorzugsweise mehrfach und/oder regelmäßig wiederholt. Insbesondere erfolgt die Bestimmung des Alterungszustands SH nach jeder Messung des Ladezustands SC und/oder der Temperatur T.

Der bestimmte Alterungszustand SH wird vorzugsweise gespeichert, insbesondere in der Datenbank 6. Es ist jedoch auch möglich, den bestimmten Alterungszustand SH alternativ oder zusätzlich in dem Akku 2, insbesondere dessen Datenspeicher 2B, dem Gerät 3 und/oder dem Kommunikationsgerät 4 zu speichern.

Nach der bzw. jeder Bestimmung des Alterungszustands SH wird vorzugsweise eine Mitteilung über den bestimmten Alterungszustand SH ausgegeben. Insbesondere erfolgt die Ausgabe der Mitteilung automatisch und/oder über das System 1, besonders bevorzugt über die Benutzerschnittstelle 7 des Systems 1. Es ist besonders bevorzugt, dass eine Ausgabe der Mitteilung durch eine Push-Benachrichtigung, eine Anzeige, ein akustisches und/oder vibratorisches Signal und/oder eine sonstige Mitteilung in einer App des Kommunikationsgeräts 4 und/oder durch optische, akustische und/oder vibratorische Ausgabe mittels des Geräts 3 und/oder Akkus 2 erfolgt.

Vorzugsweise wird der Hersteller des Akkus 2 bzw. Geräts 3 ebenfalls über den bestimmten Alterungszustand SH informiert.

Vorzugsweise wird auf Basis des bestimmten Alterungszustands SH eine Mitteilung, insbesondere eine Empfehlung, zur Nutzung und/oder Lagerung des Akkus 2 ausgegeben. Dies erfolgt insbesondere durch die Benutzerschnittstelle 7 bzw. die App des Kommunikationsgeräts 4.

Beispielsweise kann, wenn festgestellt wird, dass der Akku 2 übermäßig stark altert und/oder dass der Akku 2 (häufig) bei hohen Temperaturen T und/oder hohen Ladezuständen SC gelagert wird, dem Nutzer empfohlen werden, den Akku 2 bei geringen Temperaturen T und/oder mit einem geringeren Ladezustand SC zu lagern, insbesondere umso den Alterungsprozess zu verlangsamen bzw. die Lebensdauer des Akkus 2 zu verlängern.

Es kann auch vorgesehen sein, dass, vorzugsweise mittels der Steuerung 11, auf Basis des bestimmten Alterungszustands SH das Ladeverhalten des Systems 1 bzw. Akkus 2 automatisch angepasst wird, insbesondere in Kombination mit einem Nutzungsprotokoll, in dem die Nutzung des Akkus 2 bzw. Geräts 3 protokolliert wird.

Beispielsweise kann in dem Nutzungsprotokoll protokolliert sein, zu welchen Zeiten der Akku 2 bzw. das Gerät 3 benutzt wird/wurde und/oder wie stark der Akku 2 bei den Nutzungen entladen wurde. Insbesondere kann vorgesehen sein, dass nach einer Nutzung des Akkus 2 bzw. Geräts 3 zunächst kein Laden des Akkus 2 erfolgt, sodass der Akku 2 nach der Benutzung mit einem den Alterungsprozess weniger beschleunigenden niedrigen Ladezustand SC, beispielsweise von 50 %, gelagert wird. Alternativ oder zusätzlich kann vorgesehen sein, den Akku 2 nach einer Nutzung nicht direkt wieder aufzuladen oder nur bis zu einem bestimmten Ladezustand SC, beispielsweise 70% oder 80%, aufzuladen, sodass die Lagerung des Akkus 2 nicht mit einem Ladezustand SC von 100% erfolgt.

Des Weiteren kann vorgesehen sein, den Akku 2 erst kurz vor einer geplanten oder erwarteten erneuten Nutzung des Akkus 2 bzw. Geräts 3 wieder aufzuladen.

Alternativ oder zusätzlich kann vorgesehen sein, das Ladeverhalten des Systems 1 bzw. Akkus 2 automatisch an den bestimmten Alterungszustand SH anzupassen. Insbesondere kann bestimmten Werten des Alterungszustands SH jeweils ein maximaler und/oder minimaler Ladezustand und/oder eine maximale Ladestromstärke zugeordnet sein. Insbesondere wird das Ladeverhalten wird derart angepasst, dass die maximale Ladestromstärke nicht überschritten wird, die minimale Ladestromstärke nicht unterschritten wird und/oder ein Laden des Akkus 2 nur höchstens mit der vorgegebenen maximalen Ladestromstärke erfolgt.

Der vorgegebene maximale Ladezustand und/oder maximale Ladestromstärke sind vorzugsweise umso geringer je älter der Akku 2 ist bzw. je weiter fortgeschritten der Alterungszustand SH des Akkus 2 ist.

Wie bereits erläutert, weist der Akku 2 vorzugsweise mehrere Zellen auf. In diesem Fall erfolgt die Aufzeichnung des Ladezustands SC und/oder der Temperatur T vorzugsweise für einzelne, insbesondere alle, der Zellen separat. Auf diese Weise kann die Genauigkeit des Alterungszustands SH verbessert werden bzw. eine Bestimmung des Alterungszustands SH für einzelne Zellen oder Gruppen von Zellen separat erfolgen. Es ist nämlich grundsätzlich möglich, dass einzelne Zellen des Akkus 2 unterschiedlich schnell altern.

Vorzugsweise wird der Alterungszustand SH jeweils für einzelne Zellen bestimmt und/oder erfolgt eine Bestimmung des Alterungszustands SH des gesamten Akkus 2 anhand der Alterung bzw. des Alterungszustands SH der einzelnen Zellen des Akkus 2. Der Alterungszustand SH des Akkus 2 kann dabei ein Mittelwert oder Durchschnittswert der Alterungszustände SH einzelner Zellen sein. Es ist jedoch auch möglich, dass als Alterungszustand SH des Akkus 2 der größte Alterungszustand SH der einzelnen Zellen des Akkus 2 gewählt wird.

Vorzugsweise wird zusätzlich zu dem kalendarischen Alterungszustand SH auch ein zyklischer Alterungszustand SH des Akkus 2 bestimmt. Mit anderen Worten kann neben der kalendarischen Alterung des Akkus 2 auch die zyklische Alterung des Akkus 2 zusätzlich berücksichtigt werden.

Zur Bestimmung der zyklischen Alterung werden vorzugsweise entsprechende Bestimmungsgrößen, insbesondere eine Entladerate, Entladungstiefe, Akkutemperatur und/oder Zelltemperatur, Nachladestromstärke und/oder Nachladehöhe aufgezeichnet. Insbesondere kann auf Basis dieser Bestimmungsgrößen unter Zuhilfenahme einer Alterungsfunktion FH, die die zyklische Alterung des Akkus 2 in Abhängigkeit der Bestimmungsgrößen beschreibt, der zyklische Alterungszustand SH des Akkus 2 ermittelt werden.

Die zyklische Alterungsfunktion FH ist insbesondere akkuspezifisch und/oder wird empirisch ermittelt. Besonders bevorzugt werden zur Ermittlung der zyklischen Alterungsfunktion FH, ähnlich wie bei der Ermittlung der Alterungsfunktion FH zur Beschreibung der kalendarischen Alterung des Akkus 2, Messreihen durchgeführt, bei denen die genannten Bestimmungsgrößen variiert werden und in Abhängigkeit dieser Bestimmungsgrößen die jeweilige zyklische Alterung bestimmt wird und entsprechend die zyklische Alterungsfunktion erstellt wird.

Vorzugsweise werden zu den Zeitpunkten, zu denen der Ladezustand SC und/oder die Temperatur T gemessen und gespeichert werden, zusätzlich Informationen zu Ladevorgängen und/oder Entladevorgängen des Akkus 2, die während des jeweiligen Zeitpunkts stattfinden, aufgezeichnet. Insbesondere wird die entsprechende Ladestromstärke bzw. Entladestromstärke aufgezeichnet.

Die Informationen umfassen also insbesondere eine Ladestromstärke bzw. eine Entladestromstärke. Alternativ oder zusätzlich kann auch aufgezeichnet werden, wie lange der Ladevorgang bzw. Entladevorgang zum Zeitpunkt der Messung bereits dauert. Es kann also vorzugsweise die Dauer des Lade- bzw. Entladevorgangs bis zu dem Zeitpunkt der Messung von Ladezustand SC und/oder Temperatur T aufgezeichnet werden.

Durch diese Informationen kann insbesondere abgeschätzt werden, ob der gemessene Ladezustand und/oder die gemessene Temperatur T dem Ladezustand SC und/oder der Temperatur T entsprechen, bei der/denen der Akku 2 gelagert wird bzw. vor dem Zeitpunkt der Messung gelagert wurde oder ob der Ladezustand und/oder die Temperatur T maßgeblich durch den jeweiligen Ladevorgang bzw. Entladevorgang bestimmt bzw. verändert wurden. Beispielsweise wird der Akku 2 durch ein Laden und/oder Entladen typischerweise erwärmt, so dass die während eines Lade- bzw. Entladevorgangs gemessene Temperatur üblicherweise durch den Lade- bzw. Entladevorgang erhöht ist und nicht der Temperatur entspricht, bei der der Akku 2 bis zu dem Lade- bzw. Entladevorgang gelagert wurde.

Wenn während der Messung von Ladezustand SC und/oder Temperatur T der Akku 2 geladen oder entladen wird bzw. dies festgestellt wird, wird die Aufzeichnung von Ladezustand SC und/oder Temperatur T bzw. die Bestimmung des Alterungszustands SH vorzugsweise angepasst. Beispielsweise kann vorgesehen sein, die Messung zu ignorieren und/oder zu einem späteren Zeitpunkt zu wiederholen. Es kann auch vorgesehen sein, die Messung nur mit einem bestimmten Gewichtungsfaktor oder dergleichen bei der Bestimmung des Alterungszustands SH zu berücksichtigen.

Ferner kann auch vorgesehen sein, die Ruhespannung einzelner Zellen des Akkus 2 zu überwachen bzw. zum Zeitpunkt einer Messung und Speicherung des Ladezustands SC und/oder der Temperatur T zu messen und zu speichern. Die gemessene Ruhespannung wird vorzugsweise mit zuvor gemessenen Ruhespannungen verglichen. Falls die Ruhespannung einer Zelle besonders stark abfällt, kann dies ein Indiz für einen Fehler des Akkus 2 bzw. der Zelle sein. Insbesondere kann in diesem Fall eine entsprechende Mitteilung ausgegeben werden, insbesondere über die Benutzerschnittstelle 7 bzw. die App des Kommunikationsgeräts 4.

Vorzugsweise wird in dem System 1, insbesondere dem Akku 2, eine Information über die erste Nutzung des Akkus 2 durch einen Kunden bzw. Nutzer des Akkus 2 bzw. Geräts 3 gespeichert werden. Beispielsweise kann eine bestimmte Entladestromstärke und/oder Entladetiefe, die typisch für einen (ersten) Betrieb des Geräts 3 mit dem Akku 2 ist, als Indiz für die erste Nutzung durch den Kunden bzw. Nutzer gewertet werden. Alternativ oder zusätzlich kann auch das (erstmalige) Koppeln bzw. ein Herstellen einer datentechnischen Verbindung von dem Akku 2 mit dem Gerät 3 und/oder Kommunikationsgerät 4 als Indiz für die erste Nutzung des Akkus 2 gewertet werden. Auf diese Weise ist es möglich, die kalendarische Alterung des Akkus 2 zu unterteilen in eine Lagerung des Akkus 2 vor einer Inbetriebnahme bzw. Nutzung durch den Kunden bzw. Nutzer und eine kalendarische Alterung nach dieser Inbetriebnahme.

Vorzugsweise erfolgt die beschriebene Messung und Speicherung des Ladezustands SC und/oder der Temperatur T bzw. Bestimmung des kalendarischen Alterungszustands bereits vor der ersten Inbetriebnahme durch den Nutzer. Auf diese Weise kann kontrolliert werden, ob der Akku 2 vor der Auslieferung an den Kunden bzw. Nutzer sachgemäß gelagert wurde, beispielsweise bei einer richtigen oder vorgeschriebenen Lagertemperatur LT und/oder mit einem richtigen bzw. vorgeschriebenen Lagerladezustand LC.

Einzelne Aspekte, Merkmale und Verfahrensschritte der vorliegenden Erfindung können unabhängig voneinander, aber auch in beliebiger Kombination oder Reihenfolge realisiert werden.

### Bezugszeichenliste:

- 1: System
- 2: Akku
- 2A: Kommunikationsschnittstelle
- 2B: Datenspeicher
- 3: Gerät
- 3A: Kommunikationsschnittstelle
- 4: Kommunikationsgerät
- 4A: Kommunikationsschnittstelle
- 5: Datenverarbeitungseinrichtung
- 5A: Kommunikationsschnittstelle
- 6: Datenbank
- 6A: Kommunikationsschnittstelle
- 7: Benutzerschnittstelle
- 8: Messeinrichtung
- 9: Temperatursensor
- 10: Spannungsmesser
- 11: Steuerung

- AT: Akkutyp
- D: Daten
- FH: Alterungsfunktion
- K: Kapazität
- LC: Lagerladezustand
- LT: Lagertemperatur
- LZ: Lagerzeitraum
- R: Innenwiderstand
- SC: Ladezustand
- SH: Alterungszustand
- SN: Identifikationsnummer
- T: Temperatur

## Patentansprüche

1. Verfahren zum Betreiben eines Systems (1) mit einem Akku (2), insbesondere Lithium-Ionen-Akku,
wobei ein Ladezustand (SC) und/oder eine Temperatur (T) des Akkus (2) aufgezeichnet werden, indem der Ladezustand (SC) und/oder die Temperatur (T) zu mehreren Zeitpunkten automatisch gemessen und gespeichert werden, und
wobei mittels der gespeicherten Ladezustände (SC) und/oder Temperaturen (T) ein kalendarischer Alterungszustand (SH) des Akkus (2) automatisch bestimmt wird,
**dadurch gekennzeichnet,**
**dass** bei der Bestimmung des kalendarischen Alterungszustands (SH) eine insbesondere empirisch ermittelte und/oder akkutypspezifische Alterungsfunktion (FH) verwendet wird, wobei die Alterungsfunktion (FH) verschiedenen Lagerladezuständen (LC) und/oder Lagertemperaturen (LT) eines Akkutyps (AT) jeweils einen kalendarischen Alterungszustand (SH) nach einer Lagerung für einen oder mehrere definierte Zeiträume zuordnet, und
**dass** zur Ermittlung der Alterungsfunktion (FH) Messreihen durchgeführt werden, wobei bei den Messreihen mehrere Akkus (2) des Akkutyps (AT) für den definierten Zeitraum oder die definierten Zeiträume mit verschiedenen Lagerladezuständen (LC) und/oder bei verschiedenen Lagertemperaturen (LT) gelagert werden, wobei am Ende des definierten Zeitraums bzw. der definierten Zeiträume der jeweilige kalendarische Alterungszustand (SH) gemessen wird.

2. Verfahren nach Anspruch 1, **dadurch gekennzeichnet, dass** als Maß für den kalendarischen Alterungszustand (SH) des Akkus (2) eine Abnahme einer Kapazität (K) des Akkus (2) gegenüber einer Nennkapazität und/oder eine Zunahme eines Innenwiderstands (R) des Akkus (2) gegenüber einem Nennwiderstand bestimmt werden/wird.

3. Verfahren nach Anspruch 1 oder 2, **dadurch gekennzeichnet, dass** mehrere Alterungsfunktionen (FH) für unterschiedliche Akkutypen (AT) in einer Datenbank (6) gespeichert sind, wobei dem Akku (2) eine Information zu dem Akkutyp (AT) zugeordnet ist und wobei mittels der Information die dem Akkutyp (AT) entsprechende Alterungsfunktion (FH) zur Bestimmung des kalendarischen Alterungszustands (SH) des Akkus (2) ausgewählt wird.

4. Verfahren nach einem der voranstehenden Ansprüche, **dadurch gekennzeichnet, dass** die Bestimmung des Alterungszustands (SH) mehrfach und/oder regelmäßig wiederholt wird, insbesondere nach jeder Messung des Ladezustands (SC) und/oder der Temperatur (T) des Akkus (2), vorzugsweise wobei das System (1) eine Mitteilung über den bestimmten Alterungszustand (SH) ausgibt.

5. Verfahren nach einem der voranstehenden Ansprüche, **dadurch gekennzeichnet, dass** auf Basis des bestimmten Alterungszustands (SH) eine Mitteilung, insbesondere eine Empfehlung, zur Nutzung und/oder Lagerung des Akkus (2) ausgegeben wird und/oder ein Ladeverhalten des Systems (1) automatisch angepasst wird, insbesondere derart, dass ein dem Alterungszustand (SH) zugeordneter maximaler Ladezustand (SC) des Akkus (2) nicht überschritten wird, ein dem Alterungszustand (SH) zugeordneter minimaler Ladezustand (SC) des Akkus (2) nicht unterschritten wird und/oder ein dem Alterungszustand (SH) zugeordneter maximaler Ladestrom nicht überschritten wird.

6. Verfahren nach einem der voranstehenden Ansprüche, **dadurch gekennzeichnet, dass** die Messung und Speicherung des Ladezustands (SC) und/oder der Temperatur (T) in regelmäßigen Abständen erfolgt und/oder dass in Abhängigkeit von einer Nutzung, des Ladezustands (SC) und/oder der Temperatur (T) des Akkus (2) die Abstände der Zeitpunkte, zu denen Ladezustand (SC) und/oder Temperatur (T) gemessen werden, angepasst werden.

7. Verfahren nach einem der voranstehenden Ansprüche, **dadurch gekennzeichnet, dass** mit sinkendem Ladezustand (SC) und/oder bei Erreichen oder Unterschreiten eines unteren Grenzwerts des Ladezustands (SC) die zeitlichen Abstände, in denen der Ladezustand (SC) und/oder die Temperatur (T) gemessen werden, vergrößert werden und/oder dass bei Erreichen oder Unterschreiten eines unteren Grenzwerts des Ladezustands (SC) die Aufzeichnung des Ladezustands (SC) und/oder der Temperatur (T) beendet oder unterbrochen wird.

8. Verfahren nach einem der voranstehenden Ansprüche, **dadurch gekennzeichnet, dass** der Ladezustand (SC) und/oder die Temperatur (T) gemessen und gespeichert werden, wenn ein vordefinierter Temperaturgrenzwert erreicht, unterschritten oder überschritten wird, insbesondere zusätzlich zu der Messung und Speicherung des Ladezustands (SC) und/oder der Temperatur (T) in regelmäßigen Abständen.

9. Verfahren nach einem der voranstehenden Ansprüche, **dadurch gekennzeichnet, dass** der Akku (2) mehrere Zellen aufweist, wobei die Aufzeichnung des Ladezustands (SC) und/oder der Temperatur (T) für einzelne oder alle der Zellen separat erfolgt.

10. Verfahren nach einem der voranstehenden Ansprüche, **dadurch gekennzeichnet, dass** zu den Zeitpunkten, zu denen der Ladezustand (SC) und/oder die Temperatur (T) gemessen werden, zusätzlich Informationen zu Ladevorgängen und/oder Entladevorgängen des Akkus (2), die während des jeweiligen Zeitpunkts stattfinden, aufgezeichnet werden, vorzugsweise wobei die Informationen eine Ladestromstärke, eine Entladestromstärke und/oder eine Dauer des Ladevorgangs oder Entladevorgangs umfassen.

11. Verfahren nach Anspruch 10, **dadurch gekennzeichnet, dass**, wenn festgestellt wird, dass während der Messung von Ladezustand (SC) und/oder Temperatur (T) der Akku (2) geladen oder entladen wird, die Messung zu einem späteren Zeitpunkt, insbesondere nach Abschluss des Lade- oder Entladevorgangs, wiederholt wird und/oder bei der Bestimmung des kalendarischen Alterungszustands (SH) berücksichtigt wird, dass der Akku (2) während der Messung geladen oder entladen wurde.

12. Verfahren nach einem der voranstehenden Ansprüche, **dadurch gekennzeichnet, dass** zusätzlich zu dem kalendarischen Alterungszustand (SH) des Akkus (2) ein zyklischer Alterungszustand (SH) des Akkus (2) bestimmt wird, vorzugsweise wobei zur Bestimmung des zyklischen Alterungszustands (SH) eine Entladerate, Entladungstiefe, Zelltemperatur, Nachladestromstärke und/oder Nachladehöhe aufgezeichnet werden/wird.

13. System (1) mit einem Akku (2), vorzugsweise Lithium-Ionen-Akku, insbesondere wobei der Akku (2) zum Betreiben eines Haushaltsgeräts ausgebildet ist,
vorzugsweise wobei das System (1) zusätzlich zu dem Akku (2) ein mit dem Akku (2) betreibbares und datentechnisch verbundenes bzw. verbindbares Gerät (3), insbesondere Haushaltsgerät, ein insbesondere mit dem Akku (2) und/oder dem Gerät (3) datentechnisch verbundenes oder verbindbares Kommunikationsgerät (4), und/oder eine insbesondere mit dem Kommunikationsgerät (4), dem Gerät (3) und/oder dem Akku (2) datentechnisch verbundene oder verbindbare Datenbank (6) aufweist,
**dadurch gekennzeichnet,**
**dass** das System (1) zum Durchführen eines Verfahrens nach einem der voranstehenden Ansprüche ausgebildet ist.

14. System nach Anspruch 13, **dadurch gekennzeichnet, dass** die Datenbank (6) eine Alterungsfunktion (FH) zur Bestimmung eines kalendarischen Alterungszustands (SH) des Akkus (2) enthält, wobei die Alterungsfunktion (FH) verschiedenen Lagerladezuständen (LC) und/oder Lagertemperaturen (LT) des Akkus (2) jeweils einen kalendarischen Alterungszustand (SH) nach einer Lagerung für einen oder mehrere definierte Zeiträume zuordnet, wobei das System (1) eine Messeinrichtung (8) zur Messung des Ladezustands (SC) und/oder der Temperatur (T) des Akkus (2) und eine Kommunikationsschnittstelle (2A-6A) zur Übertragung von mit der Messeinrichtung (8) gemessenen Messwerten aufweist.

## Claims

1. Method for operating a system (1) having a rechargeable battery (2), in particular a lithium-ion rechargeable battery,
wherein a state of charge (SC) and/or a temperature (T) of the rechargeable battery (2) are recorded by automatically measuring and storing the state of charge (SC) and/or the temperature (T) at a plurality of times, and
wherein a calendar-aging state of health (SH) of the rechargeable battery (2) is automatically determined by means of the stored states of charge (SC) and/or temperatures (T),
**characterized**
**in that**, in the determination of the calendar-aging state of health (SH), an in particular empirically determined and/or rechargeable-battery-type-specific aging function (FH) is used, wherein the aging function (FH) assigns to different storage states of charge (LC) and/or storage temperatures (LT) of a rechargeable battery type (AT) in each case a calendar-aging state of health (SH) after storage for one or more defined periods of time, and
**in that**, in order to determine the aging function (FH), measurement series are carried out, wherein, in the measurement series, a plurality of rechargeable batteries (2) of the rechargeable battery type (AT) are stored for the defined period of time or the defined periods of time with different storage states of charge (LC) and/or at different storage temperatures (LT), wherein the respective calendar-aging state of health (SH) is measured at the end of the defined period of time or the defined periods of time.

2. Method according to claim 1, **characterized in that** a decrease in a capacitance (K) of the rechargeable battery (2) in relation to a rated capacity and/or an increase in an internal resistance (R) of the rechargeable battery (2) in relation to a rated resistance is/are determined as a measure of the calendar-aging state of health (SH) of the rechargeable battery (2).

3. Method according to claim 1 or 2, **characterized in that** a plurality of aging functions (FH) for different rechargeable battery types (AT) are stored in a database (6), wherein information about the rechargeable battery type (AT) is assigned to the rechargeable battery (2), and wherein, by means of the information, the aging function (FH) corresponding to the rechargeable battery type (AT) is selected in order to determine the calendar-aging state of health (SH) of the rechargeable battery (2).

4. Method according to one of the preceding claims, **characterized in that** the determination of the state of health (SH) is repeated multiple times and/or regularly, in particular after each measurement of the state of charge (SC) and/or the temperature (T) of the rechargeable battery (2), preferably wherein the system (1) outputs a notification about the determined state of health (SH).

5. Method according to one of the preceding claims, **characterized in that**, on the basis of the determined state of health (SH), a notification, in particular a recommendation, for use and/or storage of the rechargeable battery (2) is output and/or a charging behavior of the system (1) is automatically adapted, in particular in such a way that a maximum state of charge (SC) of the rechargeable battery (2) assigned to the state of health (SH) is not exceeded, a minimum state of charge (SC) of the rechargeable battery (2) assigned to the state of health (SH) is not undershot and/or a maximum charging current assigned to the state of health (SH) is not exceeded.

6. Method according to one of the preceding claims, **characterized in that** the measuring and storing of the state of charge (SC) and/or the temperature (T) takes place at regular intervals and/or **in that** the intervals of the times at which the state of charge (SC) and/or the temperature (T) are measured are adapted depending on a use, the state of charge (SC) and/or the temperature (T) of the rechargeable battery (2).

7. Method according to one of the preceding claims, **characterized in that**, as the state of charge (SC) falls and/or when a lower limit value of the state of charge (SC) is reached or undershot, the time intervals at which the state of charge (SC) and/or the temperature (T) are measured are increased and/or **in that**, when a lower limit value of the state of charge (SC) is reached or undershot, the recording of the state of charge (SC) and/or the temperature (T) is ended or interrupted.

8. Method according to one of the preceding claims, **characterized in that** the state of charge (SC) and/or the temperature (T) are measured and stored when a predefined temperature limit value is reached, undershot or exceeded, in particular in addition to the measuring and storing of the state of charge (SC) and/or the temperature (T) at regular intervals.

9. Method according to one of the preceding claims, **characterized in that** the rechargeable battery (2) has a plurality of cells, wherein the recording of the state of charge (SC) and/or the temperature (T) takes place separately for individual or all of the cells.

10. Method according to one of the preceding claims, **characterized in that**, at the times at which the state of charge (SC) and/or the temperature (T) are measured, information about charging processes and/or discharging processes of the rechargeable battery (2) which take place during the respective time is additionally recorded, preferably wherein the information comprises a charging current strength, a discharging current strength and/or a duration of the charging process or discharging process.

11. Method according to claim 10, **characterized in that**, if it is determined that the rechargeable battery (2) is charged or discharged during the measurement of the state of charge (SC) and/or the temperature (T), the measurement is repeated at a later time, in particular after completion of the charging or discharging process, and/or it is taken into account in the determination of the calendar-aging state of health (SH) that the rechargeable battery (2) was charged or discharged during the measurement.

12. Method according to one of the preceding claims, **characterized in that**, in addition to the calendar-aging state of health (SH) of the rechargeable battery (2), a cyclic state of health (SH) of the rechargeable battery (2) is determined, preferably wherein, in order to determine the cyclic state of health (SH), a discharge rate, discharge depth, cell temperature, recharging current strength and/or recharging level is/are recorded.

13. System (1) having a rechargeable battery (2), preferably a lithium-ion rechargeable battery, in particular wherein the rechargeable battery (2) is designed for operating a domestic appliance,
preferably wherein the system (1) has, in addition to the rechargeable battery (2), a device (3), in particular a domestic appliance, which is operable with the rechargeable battery (2) and is or can be connected with the rechargeable battery (2) in terms of data technology, a communication device (4), in particular a communication device (4) which is or can be connected with the rechargeable battery (2) and/or the device (3) in terms of data technology, and/or a database (6), in particular a database (6) which is or can be connected with the communication device (4), the device (3) and/or the rechargeable battery (2) in terms of data technology,
**characterized**
**in that** the system (1) is designed for carrying out a method according to one of the preceding claims.

14. System according to claim 13, **characterized in that** the database (6) contains an aging function (FH) for determining a calendar-aging state of health (SH) of the rechargeable battery (2), wherein the aging function (FH) assigns to different storage states of charge (LC) and/or storage temperatures (LT) of the rechargeable battery (2) in each case a calendar-aging state of health (SH) after storage for one or more defined periods of time, wherein the system (1) has a measuring device (8) for measuring the state of charge (SC) and/or the temperature (T) of the rechargeable battery (2) and a communication interface (2A-6A) for transmitting measured values measured with the measuring device (8).

## Revendications

1. Procédé de fonctionnement d'un système (1) comprenant une batterie (2), en particulier une batterie lithium-ion,
dans lequel un état de charge (SC) et/ou une température (T) de la batterie (2) sont enregistrés en mesurant et en mémorisant automatiquement l'état de charge (SC) et/ou la température (T) à plusieurs instants, et
dans lequel un état de vieillissement (SH) de la batterie (2) est déterminé automatiquement au moyen des états de charge (SC) et/ou températures (T) mémorisés,
**caractérisé en ce que**
lors de la détermination de l'état de vieillissement (SH), une fonction de vieillissement (FH) en particulier déterminée empiriquement et/ou spécifique au type de batterie est utilisée, la fonction de vieillissement (FH) associant à différents états de charge de stockage (LC) et/ou températures de stockage (LT) d'un type de batterie (AT) respectivement un état de vieillissement (SH) après un stockage pendant une ou plusieurs périodes définies, et
**en ce que** pour la détermination de la fonction de vieillissement (FH), des séries de mesure sont effectuées, dans lequel, dans les séries de mesure, plusieurs batteries (2) du type de batterie (AT) sont stockées pendant la période définie ou les périodes définies avec différents états de charge de stockage (LC) et/ou à différentes températures de stockage (LT), l'état de vieillissement (SH) respectif étant mesuré à la fin de la période définie ou des périodes définies.

2. Procédé selon la revendication 1, **caractérisé en ce qu'**une diminution d'une capacité (K) de la batterie (2) par rapport à une capacité nominale et/ou une augmentation d'une résistance interne (R) de la batterie (2) par rapport à une résistance nominale est/sont déterminée(s) en tant que mesure pour l'état de vieillissement (SH) de la batterie (2).

3. Procédé selon la revendication 1 ou 2, **caractérisé en ce que** plusieurs fonctions de vieillissement (FH) pour différents types de batterie (AT) sont mémorisées dans une base de données (6), une information concernant le type de batterie (AT) étant associée à la batterie (2) et la fonction de vieillissement (FH) correspondant au type de batterie (AT) étant sélectionnée au moyen de l'information pour la détermination de l'état de vieillissement (SH) de la batterie (2).

4. Procédé selon l'une quelconque des revendications précédentes, **caractérisé en ce que** la détermination de l'état de vieillissement (SH) est répétée plusieurs fois et/ou régulièrement, en particulier après chaque mesure de l'état de charge (SC) et/ou de la température (T) de la batterie (2), de préférence le système (1) émettant une notification concernant l'état de vieillissement (SH) déterminé.

5. Procédé selon l'une quelconque des revendications précédentes, **caractérisé en ce qu'**une notification, en particulier une recommandation, concernant l'utilisation et/ou le stockage de la batterie (2) est émise sur la base de l'état de vieillissement (SH) déterminé et/ou un comportement de charge du système (1) est adapté automatiquement, en particulier de telle sorte qu'un état de charge (SC) maximal de la batterie (2) associé à l'état de vieillissement (SH) n'est pas dépassé, qu'un état de charge (SC) minimal de la batterie (2) associé à l'état de vieillissement (SH) n'est pas dépassé et/ou qu'un courant de charge maximal associé à l'état de vieillissement (SH) n'est pas dépassé.

6. Procédé selon l'une quelconque des revendications précédentes, **caractérisé en ce que** la mesure et la mémorisation de l'état de charge (SC) et/ou de la température (T) sont effectuées à intervalles réguliers et/ou **en ce que** les intervalles des instants auxquels l'état de charge (SC) et/ou la température (T) sont mesurés sont adaptés en fonction d'une utilisation, de l'état de charge (SC) et/ou de la température (T) de la batterie (2).

7. Procédé selon l'une quelconque des revendications précédentes, **caractérisé en ce qu'**à mesure que l'état de charge (SC) diminue et/ou lorsqu'une valeur limite inférieure de l'état de charge (SC) est atteinte ou n'est pas atteinte, les intervalles temporels dans lesquels l'état de charge (SC) et/ou la température (T) sont mesurés sont augmentés et/ou **en ce que** lorsque la valeur limite inférieure de l'état de charge (SC) est atteinte ou n'est pas atteinte, l'enregistrement de l'état de charge (SC) et/ou de la température (T) est terminé ou interrompu.

8. Procédé selon l'une quelconque des revendications précédentes, **caractérisé en ce que** l'état de charge (SC) et/ou la température (T) sont mesurés et mémorisés lorsqu'une valeur limite de température prédéfinie est atteinte, n'est pas atteinte ou est dépassée, en particulier en plus de la mesure et de la mémorisation de l'état de charge (SC) et/ou de la température (T) à intervalles réguliers.

9. Procédé selon l'une quelconque des revendications précédentes, **caractérisé en ce que** la batterie (2) comprend plusieurs cellules, l'enregistrement de l'état de charge (SC) et/ou de la température (T) étant effectué séparément pour des cellules individuelles ou pour toutes les cellules.

10. Procédé selon l'une quelconque des revendications précédentes, **caractérisé en ce que** des informations concernant des processus de charge et/ou des processus de décharge de la batterie (2) qui ont lieu pendant l'instant respectif sont enregistrées en plus aux instants auxquels l'état de charge (SC) et/ou la température (T) sont mesurés, de préférence les informations comprenant une intensité de courant de charge, une intensité de courant de décharge et/ou une durée du processus de charge ou du processus de décharge.

11. Procédé selon la revendication 10, **caractérisé en ce que**, lorsqu'il est constaté que la batterie (2) est chargée ou déchargée pendant la mesure de l'état de charge (SC) et/ou de la température (T), la mesure est répétée à un instant ultérieur, en particulier après l'achèvement du processus de charge ou de décharge, et/ou il est pris en compte lors de la détermination de l'état de vieillissement (SH) que la batterie (2) a été chargée ou déchargée pendant la mesure.

12. Procédé selon l'une quelconque des revendications précédentes, **caractérisé en ce qu'**un état de vieillissement (SH) cyclique de la batterie (2) est déterminé en plus de l'état de vieillissement (SH) de la batterie (2), de préférence un taux de décharge, une profondeur de décharge, une température de cellule, une intensité de courant de recharge et/ou un niveau de recharge étant enregistré(s) pour la détermination de l'état de vieillissement (SH) cyclique.

13. Système (1) comprenant une batterie (2), de préférence une batterie lithium-ion, en particulier la batterie (2) étant conçue pour faire fonctionner un appareil ménager,
de préférence le système (1) comprenant, en plus de la batterie (2), un appareil (3), en particulier un appareil ménager, pouvant fonctionner avec la batterie (2) et relié ou pouvant être relié par une technique de données, un appareil de communication (4) relié ou pouvant être relié par une technique de données en particulier à la batterie (2) et/ou à l'appareil (3), et/ou une base de données (6) reliée ou pouvant être reliée par une technique de données en particulier à l'appareil de communication (4), à l'appareil (3) et/ou à la batterie (2),
**caractérisé en ce que**
le système (1) est conçu pour mettre en oeuvre un procédé selon l'une quelconque des revendications précédentes.

14. Système selon la revendication 13, **caractérisé en ce que** la base de données (6) contient une fonction de vieillissement (FH) pour la détermination d'un état de vieillissement (SH) de la batterie (2), la fonction de vieillissement (FH) associant à différents états de charge de stockage (LC) et/ou températures de stockage (LT) de la batterie (2) respectivement un état de vieillissement (SH) après un stockage pendant une ou plusieurs périodes définies, le système (1) comprenant un dispositif de mesure (8) pour la mesure de l'état de charge (SC) et/ou de la température (T) de la batterie (2) et une interface de communication (2A-6A) pour la transmission de valeurs de mesure mesurées avec le dispositif de mesure (8).
